# EUROPEAN PATENT APPLICATION

(11) **EP 4 770 285 A1**
(43) Date of publication of application: **01.07.2026**
(21) Application number: 24223637.0
(22) Date of filing: 30.12.2024
(51) Int. Cl.: H05K 3/14, H05K 3/00, H05K 3/34, H05K 1/02

(54) **METHOD OF MANUFACTURING A PRODUCT COMPRISING POLYMER STRUCTURE AND METALLIC STRUCTURES**

(71) Applicant: Hahn-Schickard-Gesellschaft für angewandte Forschung e. V., 70569 Stuttgart (DE)
(72) Inventor: SHU, Zhe, 79224 Umkirch (DE); KHAN, Zeba, 79117 Freiburg i. Br. (DE); STRAUBINGER, Daniel, 79114 Freiburg i. Br. (DE); KARTMANN, Sabrina, 79104 Freiburg i. Br. (DE); ROMBACH, Markus, 79111 Freiburg i. Br. (DE); KOCH, Philip, 79114 Freiburg i. Br. (DE)
(74) Representative: Stöckeler, Ferdinand

(57) **Abstract**

Method (100) of manufacturing a product, the method comprising: melting (104) a solid metal material to obtain a molten metal material; applying (108) the molten metal material onto a polymer structure deformable by applying heat and/or pressure, wherein the molten metal material solidifies upon coming into contact with the polymer structure so as to form metallic structures of customizable shape and structure; and three-dimensional deforming (112) the polymer structure including the metallic structures by providing heat and/or pressure to the polymer structure including the metallic structures so as to obtain a specific shape.

## Description

### Technical Field

Embodiments of the present invention relate to a method of manufacturing a product comprising polymer structure and metallic structures, and to a product obtainable by such method.

### Technical Background

In-Mold Electronics (IME) is a process of integrating printed decorations and functional electronics with In-Mold Decorations (IMD) (i.e. thermoforming and injection molding), resulting in 3D-shaped objects with embedded electronic functions [1]. References [2-3] provide a good overview of IME.

Printed electronics is a set of printing materials used to create electrical devices on various substrates. Printing typically uses common printing equipment suitable for defining patterns on material, such as screen printing, flexography, gravure, offset lithography, and inkjet [4].

In scientific research, liquid metals refer to a class of metallic materials that remain in a liquid state at or near room temperature. These materials possess unique properties, such as a high electrical and thermal conductivity, low vapor pressure, and the ability to deform and flow like a liquid while retaining metallic characteristics. The typical examples of liquid metals are:
- Gallium (Ga): melting point of 29.76 °C with an electrical conductivity of 7.1×10⁶ S/m
- Eutectic Gallium-Indium (EGaln): melting point of -12.6 °C with an electrical conductivity of 3.28 × 10⁶ S/m
- Galinstan (an alloy composed of gallium, indium and tin): melting point of - 19 °C with an electrical conductivity of 3.46 × 10⁶ S/m

The liquid metals tend to oxidize fast and are typically processed under inert atmosphere (mostly under argon).

Printed electronics often use conductive inks, which are specially engineered materials that can be printed and processed to conduct electricity. These inks can be made from a variety of materials, including metal nanoparticles / flasks / microparticles (providing conductivity) with encapsulation of outer shells, organic solvents, and additives (providing adhesion and printability).

In contrast, "bulk metal" can refer to almost 100% raw materials made of metal or its alloys. Examples are raw metal tin, and solder materials without flux such as tin silver copper alloys (SAC305) and tin bismuth alloy.

The typical solder wires in the market enclose flux material in the core of the wire. Commercial solder without flux and additive is typically referred to as "solid" or "massive". For example, the typical solder paste is a mixture of solder particles without flux, solvents and additives, e.g. the SAC305 solder paste [5].

Various forms of the bulk metal can be used:
- wired form [6],
- bar form [7], and

Molten metal printing technology (liquid metal printing technology) refers to a method and technology which can dispense the bulk metal in its molten state (i.e. liquid phase) and form a metal structure on a substrate. The molten state can be realized by heating up above its melting point (superheating).

StarJet technology is an invention from the University of Freiburg [8-9]. It is a molten metal printing technology that can non-contact dispense bulk metal in the form of single microdroplets or continuous jet. This technology is being developed further and the application potential is being explored in various fields, such as
- Additive manufacturing [10],
- Multi-material additive manufacturing of 3D electronics [11-14],
- Non-contact selective soldering [15-16], and
- Printed electronics [17-18].

In various application fields such as automotive interiors, household appliances, and medical devices, more and more electronics have to be integrated onto/into 3D surfaces and 3D housings for functional, space-saving and cost-saving purposes.

In the field of automotive interior electronics, molded automotive interior parts such as capacitive sensors, heaters and interconnections can be manufactured using inkjet/screen printing; however with many issues resulting from ink-based metal surfaces.

A tear-down of traditional control panels indicates that that they usually consist of injection molded 3D plastic housing, electronic components, PCB boards and other assembly accessories. In contrast with the traditional control panels, structural in-mold electronics control panel design can save 70 % weight and 90 % thickness. For example, a traditional control panel having a weight of 578 g and a depth of 60 mm usually has more than 25 tools and more than 60 assemblies, whereas a structural IME control panel having a weight of 160 g and a depth of 3 mm has only 2 tools and 1 part.

As illustrated in Table 1, the emerging in-mold electronics (IME) can bring huge benefits in integrating electronics into 3D shapes, such as:
• Significant reduction in space and weight
• Greater design flexibility
• Improved reliability and durability
• Ease of assembly
• Sustainability
• Improved touch/sensing performance

**Table 1**

| | Standard Design | IME Design | Difference |
|---|---|---|---|
| Weight | 650 g | 150 | -77% |
| Thickness | 45 mm | 3 mm (flat version) | -93 % |
| Mechanical parts | 64 pcs. | 2 pcs. | -96 % |

IME is a relatively new innovation, but it builds on earlier technologies like In-mold decoration (IMD) and In-mold labelling (IML) (see [19] and [20] respectively). The first commercial implementation of IME was realized in an innovative overhead console for a Ford car in 2012. Today, IME has been expanded to household appliances, automotive dashboards, medical equipment, aerospace, and wearable electronics.

As IME is a relatively new innovation, the market is currently not too big with a global market of ~ 189 M$ in 2023. However, it has been projected to be a strong expansion with a projected market size of 2358 M$ in the year 2033 [1].

The typical workflow of state-of-the-art IME process is as follows:
- Step 1: Screen-printing of graphics and conductive tracks with functional inks on thin polyester or polycarbonate film (can be multi-layers)
- Step 2: Sintering of the conductive tracks
- Step 3: Thermoforming gives printed media a 3D shape
- Step 4 (optional): Injection mold the cover plastics

Current methods produce structured electrical circuits mainly through printed electronics technology such as screen printing, inkjet printing, aerojet printing, etc. These methods mainly use metal particle based inks or paste from silver, copper, gold or carbon. The digital printing technology can achieve relatively good results. Nevertheless, the digital printing technology is reliant on dedicated ink formulations.

Even though the IME, which combines the in-mold decoration and printed electronics technologies, shows huge market potential, the technology itself is still young and the industry is still facing various technical challenges, in particular, for 3D forming printed conductive traces, such as:
- Specific and expensive inks are required: Dedicated inks are typically made from metal nanoparticles/micro-flakes (e.g. silver, copper) and are typically much more expensive than the raw metal itself. Further, dedicated ink formulations are required so that the printed and cured metal can survive the thermal forming and stretching process.
- Limited polymer selection: The high temperatures to which the polymer is exposed during sintering and injection molding restricts the kinds of polymer than can be used. Specifically, only polymers with sufficiently high melting points can be used with conventional technology. Further, the polymers are usually required to be compatible with ink-based printing, which poses an additional limiting factor in the selection of polymers.
- Cracks and defects during the 3D thermal forming process: Functional inks (e.g. silver nanoparticle inks) do not withstand high pressure and temperature under thermoforming, leading to cracking, line breaking, etc. Since the printed traces are made using such inks and consist of sintered metal nanoparticles, they are porous in microscopic view and can lead to cracks, irregular changes of electrical resistance, and other defects by high pressure and thermal impact during the thermal forming process. For example, printed traces face defects in reliability tests such as thermal cyclic tests in automotive applications. Dedicated design rules, inks, and processes overcoming structural defects are required.
- Process challenges: Conventional technology uses complex process which involve multiple challenging stages. These stages comprise: printing, drying and curing, possibly multiple, functional materials; optimization of the printing process for each substrate (e.g. PC, PET, etc.); and additional overmolding (e.g. injection molding) to increase reliability. Further, when using conductive (metal) inks the process usually needs post-treatment and/or pre-treatment of the inks. Conventional technologies (prior art) require drying of the solvent inside the metal ink and curing (e.g. heating at 200 °C in oven) of the metal inks, which make the process more expensive and inflexible.
- Low yield: Inkjet/screen printing has a general reproducibility issue. The printing of different inks on different polymers is challenging to reproduce. The printed structures are not identical after using the same printing parameters and sintering parameters.

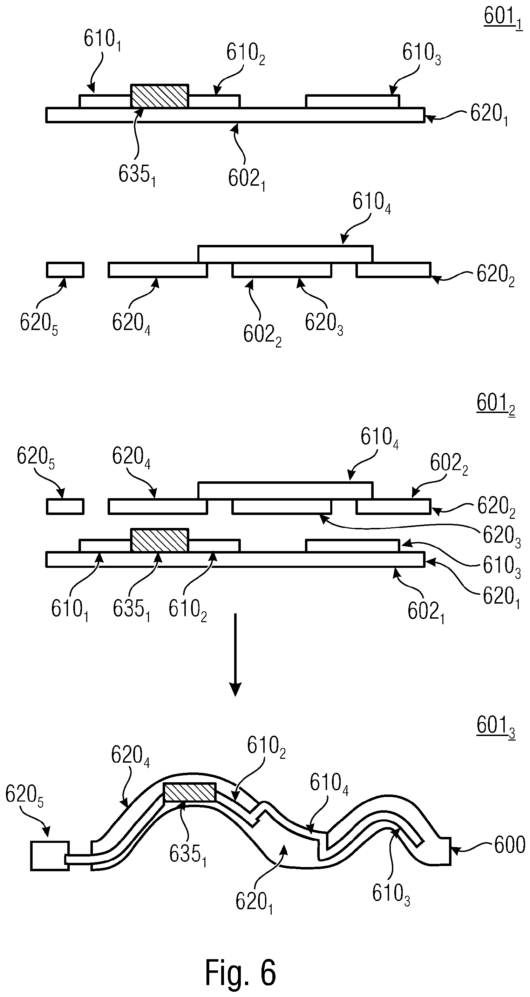

This indicates a low fidelity of the printed structures and thus, results in a low yield of the printed structures (e.g. printed conductive traces).
- Limited electrical performance: The printed electrical traces are typically super thin (< 1 µm in thickness) which leads to higher electrical resistance. In the meantime, the printed ink needs to be sintered (e.g. at high temperature) to merge the metal particles. Due to the temperature sensitivity of the polymer foils, the sintering condition is compromised, which also leads to limited electrical conductivity. That is, using conventional technology, electrical conductivity is limited due to printed thin films and sintering. For example, a typical IME ink, such as [21], is required to be sintered at 120 °C for 20 minutes and has still a relatively high electrical resistivity after thermal forming (~ 300 mΩ/sq/mil). The best conductivity achieved in [22] is 10.2 µΩcm which equals 9.8 × 10⁶ S/m, however the conductivity reduces a couple of 100 times after applying strain (see Fig. 6 of [22]).
- Environmental issue: Inks or pastes contain various chemical organic solvents. The production and disposal of such solvents is an environmental issue. Further, recycling printed metal is also difficult due to complex composition of the inks.

WO 2022/180577 A1 relates to a method for obtaining a flexible printed circuit with an solid-state electric or electronic component, the method comprising: printing an electric circuit with a conductive flexible polymer-based ink over a polymeric substrate in the solid state, wherein both polymers in the ink and the substrate are reversible solid-gel phase transition polymers; placing the component over the substrate and over the electric circuit; applying an external stimulus that results in a solid to gel transition of the polymeric substrate and ink, such that the component penetrates into the softened substrate, establishing an electrical contact of the component with the printed circuit.

US 11 161 996 B2 relates to an electronic device comprising a printed substrate comprising a trace of molecular ink thereon, the molecular ink being sintered to form a conductive metal trace forming the electronic device, wherein the molecular ink is chosen from a) a flake-less printable composition of 30-60 wt % of a C8-C12 silver carboxylate, 0.1-10 wt % of a polymeric binder and balance of at least one organic solvent, all weights based on total weight of the composition; or b) a flake-less printable composition of 5-75 wt % of bis(2-ethyl-1-hexylamine) copper (II) formate, bis(octylamine) copper (II) formate or tris(octylamine) copper (II) formate, 0.25-10 wt % of a polymeric binder and balance of at least one organic solvent, all weights based on total weight of the composition.

EP 3 682 717 A1 relates to coating inkjet-printed traces of silver nanoparticles (AgNP) ink with a thin layer of eutectic gallium indium (EGaln) increases the electrical conductivity and significantly improves tolerance to tensile strain. This enhancement is achieved through a room temperature "sintering" process in which the liquid-phase EGaln alloy binds the AgNP particles to form a continuous conductive trace. These mechanically robust thin-film circuits are well suited for transfer to highly curved and non-developable 3D surfaces as well as skin and other soft deformable substrates.

### Summary

Therefore, there is a particular need for a technology that can circumvent a reliance on printed (conductive) inks and pastes and permit manufacturing of products with customizable shapes and structures with improved structural, operational and electrical characteristics.

Such a need is fulfilled, and multiple advantages are provided, by a method of manufacturing a product according to claim 1 and a product obtainable by a method according to claim 15. Further, specific embodiments of the present inventive concept are defined in the dependent claims.

According to embodiments of the present inventive concept, method of manufacturing a product comprises melting a solid metal material to obtain a molten metal material; applying the molten metal material onto a polymer structure deformable by applying heat and/or pressure, wherein the molten metal material solidifies upon coming into contact with the polymer structure so as to form metallic structures of customizable shape and structure; and three-dimensional deforming the polymer structure including the metallic structures by providing heat and/or pressure to the polymer structure including the metallic structures so as to obtain a specific shape.

Therefore, the method permits a utilization of the solid metal material by melting it to obtain its molten form. The method further facilitates a fabrication of the metallic structures of customizable shape and structure by applying the molten metal material onto the polymer structure and achieving the solidification of the applied molten metal material while in contact with the polymer structure. The method further achieves a customization of the polymer structure including the metallic structures having the specific shape by three-dimensional deforming it with heat and/or pressure.

As the method allows creating the metallic structures by directly using the solid metal material, which is without a use of solvents and non-metallic additives, the metallic structures comprising the solid metal material are therefore able to withstand high pressure and temperature during the three-dimensional deforming. In contrast to printed (conductive) inks, the metallic structures do not give rise to structural defects such as cracks and line breaks and do not result in unfavorable electrical performance (e.g. irregular changes in electrical resistance, deviations in electrical conductivity) owing to the high pressure and thermal impact of the 3D deforming. By this measure, the method allows manufacturing the product with more reliable structural characteristics. Further, due to the three-dimensional deforming, the decrease in electrical conductivity of the metallic structures may be kept relatively small as compared to printed (conductive) inks. Hence, this method allows manufacturing products with increased reliability, robust structural characteristics and improved electrical performance.

Further, conductive inks or pastes comprise various chemical organic solvents whose production and disposal poses an environmental challenge. The method of the present inventive concept allows manufacturing of the product without involving such solvents and hence, the method manufactures products in a manner overcoming the described environmental challenge.

The method benefits from achieving the phase change, i.e. the solidification, of the molten metal material to the solidified molten metal material upon coming into contact with the polymer structure which provides a high adhesion of the metallic structures with the polymer structure. In this regard, the method does not involve a dedicated treatment (e.g. curing) of the metal material to establish its adhesion to the polymer structure, as opposed to conventional methods involving conductive inks.

The method according to the present inventive concept permits a wide variety of polymers to be used since it does not subject the polymer structure to the high temperatures and pressures as needed in additional treatment such as sintering. Since the method does not involve ink-based printing, polymers of the polymer structure are not required to be compatible with ink-based printing techniques. Therefore, the method mitigates thermal compatibility issues (e.g. which adversely affect conventional technology) by allowing the use of various kinds of polymers.

As the method comprises three-dimensional deforming of the metallic structure along with the polymer structure into the specific shape, the product can be manufactured having the desired shape and structure. Since the metallic structures including the polymer structure have a high forming flexibility and thus can be shaped as preferred, the method provides manufacturing the product with enhanced shape fidelity, allowing greater reproducibility which results in an improved yield.

The method does not involve additional treatment of the metal material either prior to or post (e.g. curing; e.g. sintering; e.g. plasma surface activation) its application to the polymer structure, and as a result, the overall manufacturing process provided by the method is highly simplified, in contrast to the numerous complex and challenging stages involved in conventional technologies. In particular, dedicated treatments needed for printed inks and pastes increase the cost and time associated with manufacturing and additionally add to the complexity of the manufacturing process. In contrast, the method traverses the need for these dedicated treatments and allows a cheaper and a more efficient technology for manufacturing the product. Hence, the present inventive concept presents a simpler and less challenging method of manufacturing the product.

Further, the method according to the present inventive concept achieves a reduction in costs associated with the manufacturing of the product which results from using cost-efficient solid metal material. For example, thermal forming inks (conductive inks) may cost more than 2600 €/kg while the solid metal material may cost less than 80 €/kg.

Therefore, the method according to the present inventive concept takes benefit of a wider variety of polymers, forms metallic structures with customizable shapes and structures, enhances structural characteristics of the product, and reduces the complexity of the overall manufacturing process while achieving a better electrical performance and an improved yield compared to the state of the art.

According to some embodiments, the three-dimensional deforming may be performed so that the metallic structures and the polymer structure having the specific shape are conformally formed. Therefore, the method may permit manufacturing the product with conformally formed metallic structures and polymer structure.

According to some embodiments, the solidified molten metal material may be sunken into the polymer structure. By this measure, the product comprises metallic structures merged with (e.g. arranged on an outer surface) or within (e.g. partially or fully embedded in a body of) the polymer structure. Hence, the solidified metal material may be (e.g. partially or fully) pushed into the polymer structure forming the metallic structure and exhibits high adhesion between the metal material and the polymer structure.

According to some embodiments, the metallic structures may comprise at least one electrical conductor track, preferably, comprising a linewidth ranging between 10 and 1000 µm, within a tolerance range. Therefore, the method may allow manufacturing the product with the at least one electrical track comprising relatively larger linewidth than the state of the art. For example, the at least one electrical conductor track may comprise linewidth of up to a few hundred µm (e.g. 100 µm, 300 µm, 500 µm, or 750 µm) or up to around 1 mm. The increased linewidth of the electrical conductor track leads to high electrical conductance after the 3D deforming and thus the method may provide an enhanced electrical performance of the manufactured product.

According to some embodiments, the method may further comprise applying one or more electronic and/or photonic components (for example SMD components) onto the polymer structure; and interconnecting the metallic structures and the one or more electronic and/or photonic components before or after the three-dimensional deforming of the polymer structure including the metallic structures. By this measure, the method may permit the one or more electronic and/or photonic components to be integrated within the product for equipping it with desired functionalities.

According to some embodiments, the method may further comprise applying the molten metal material as microdroplets and/or jets onto the polymer structure from a specific distance, preferably by applying the molten metal material onto the polymer structure through a nozzle. By this measure, the method may achieve an application of the molten metal material onto the polymer structure without being in direct contact with the polymer structure during the application. The thermal impact created by the application of the molten metal material upon the polymer structure may be localized and tunable, and hence may further aid in the adhesion of the metal material with the polymer structures

According to some embodiments, the method may further comprise providing a multi-layer structure comprising a plurality of polymer layers, wherein metallic structures are formed on at least two of the plurality of polymer layers by applying the molten metal material onto the corresponding polymer layer; and generating further metallic structures by interconnecting the corresponding metallic structures formed on different polymer layers before or after three-dimensional deforming the multi-layer structure. Thus, the method may allow manufacturing products comprising interconnections (e.g. vertical interconnections) established using the further metallic structures between the pluralities of polymer layers. This means that the method may enable manufacturing products with three dimensional, possibly vertically arranged, complex structures of a desired shape. For example, the product may relate to conformal multi-layer electronics such as a 3D-printed multi-layer printed circuit board (PCB) having the specific shape.

According to some embodiments, the method may further comprise applying at least one electronic and/or photonic component onto at least one of the plurality of polymer layers, wherein at least one of the metallic structures and/or at least one of the further metallic structures is connected to the at least one electronic and/or photonic component. By this measure, the electronic and/or photonic components (which may possibly be pre-fabricated) can be arranged and connected to any of the metallic structure and/or the further metallic structures, and thus, the method may allow manufacturing complex 3D electronics comprising vertical and/or horizontal interconnections among its different components (e.g. electrodes, conductor tracks, sensors). For example, the further metallic structures may comprise at least one electrical conductor track, preferably, comprising a linewidth ranging between 10 and 1000 µm.

According to some embodiments, the polymer structure or the plurality of polymer layers may have a melting point in a range between 50° - 500° C, wherein the polymer structure or the plurality of polymer layers preferably comprise cyclic olefin copolymer, COC. Hence, the method may permit using a variety of polymers, including polymers with low melting points, for example polymers with melting points up to 50° C or melting points up to 60° C.

According to additional embodiments of the present inventive concept, a product obtainable by a method according to the present inventive concept and embodiments thereof, comprises a polymer structure; one or more electronic and/or photonic components; metallic structures comprising a metal material, preferably, wherein the metallic structures are connected to at least one of the one or more electronic and/or photonic components; wherein the metal material of the metallic structures is sunken into the polymer structure; wherein the metallic structures and the polymer structure together are three-dimensionally deformed to have obtain the specific shape; and wherein the metallic structures and the polymer structure having the specific shape are conformally formed.

### Brief Description of the Figures

Embodiments of the present invention are described herein in brief detail with respect to the appended drawings and figures, in which:
- Fig. 1: shows a schematic block diagram of a method of manufacturing a product in accordance with the present inventive concept;
- Fig. 2a-b: a schematic illustration of an implementation of the method of manufacturing a product in accordance with some embodiments;
- Fig. 3a-b: shows schematic illustrations of an implementation of the method according to some embodiments;
- Fig. 4: shows a schematic illustration of an implementation of the method of manufacturing a product relating to in-mold electronics on foils in accordance with some embodiments;
- Fig. 5: shows a schematic illustration of an implementation of the method of manufacturing a product relating to conformal multilayer electronics in accordance with some embodiments;
- Fig. 6: shows a schematic illustration of another implementation of the method of manufacturing a product relating to conformal multilayer electronics in accordance with some embodiments;
- Fig. 7a-b: shows a schematic illustration of an implementation of the method of manufacturing a product relating to complex 3D electronics in accordance with some embodiments.

### Detailed Description of the Figures

In the following description, embodiments are discussed in detail, however, it should be appreciated that the embodiments provide many applicable concepts that may be embodied in a wide variety of the field of In-Mold Electronics, IME. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled in the art that other embodiments may be practised without these specific details. In other instances, well-known structures and devices are shown in diagram form rather than in detail in order to avoid obscuring examples described herein. In addition, features of the different embodiments described herein may be combined with each other, unless specifically noted otherwise.

Equal or equivalent elements or elements with equal or equivalent functionality are denoted in the following description by equal or equivalent reference numerals even if occurring in different figures.

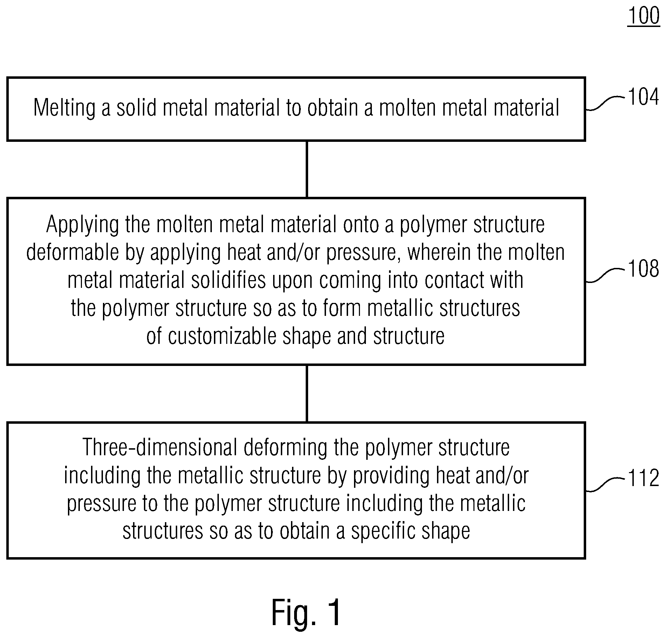

A method 100 of manufacturing a product, in accordance with the present inventive concept, is now described with respect to the schematic block diagram of Fig. 1. Fig. 1 shows in block diagram form the different stages of the method 100.

The first block of Fig. 1 depicts that the method 100 comprises melting 104 a solid metal material to obtain a molten metal material. The melting 104 is performed in a manner so that the solid metal material is brought to a temperature higher than its melting point and undergoes a phase change (e.g. a reversible phase change) to obtain the molten metal material. The melting 104 comprises heating the solid metal material to a temperature above its melting point to obtain the molten metal material. This means that melting 104 comprises superheating the solid metal material. This action 104 of transforming the solid metal material may be carried out using a dedicated melting apparatus through an application of an external stimuli. The external stimuli may comprise force, heat, pressure, electromagnetic fields, or gas/vapor or the aforementioned in combinations. The dedicated melting apparatus may be particularly configured to transform the solid metal material to the molten metal material and vice versa; it is preferable that the dedicated melting apparatus may be adapted to carry out such transformations at least one time, or even repeatedly when desired.

It is emphasized in the present disclosure that the solid metal material is referred to metals or alloys or metallic materials that exhibit a solid phase/state at or around room temperatures, in contrast with liquid metals which are liquid at or around room temperatures. The solid metal material is capable of a, possibly reversible, phase change to a liquid state upon exposure to temperatures substantially higher than the melting point of the solid metal material.

In accordance with embodiments, the solid metal material may have a melting point in a range between 100° - 1200° C. In accordance with embodiments, the solid metal material may, whilst not excluding other materials, preferably comprise at least one of at least one of tin (Sn), tin silver copper solder (SAC305 - 96.5Sn-3.5Ag-0.5Cu alloy), bismuth tin silver solder (57Bi-42Sn-1Ag), ZAMAK (Zinc aluminum alloy) and aluminum alloy (e.g. AlSi₁₂). For example, the solid metal material may comprise 57Bi-42Sn-1Ag, its melting range may lie in a range of 137-139 °C. For example, the solid metal material may comprise tin alloys.

In the following, we provide a number of non-limiting examples of the described solid metal material. It is noted that the following examples do not preclude or restrict other suitable metal materials generally known to persons skilled in the art. For example, the solid metal material may comprise a pure metal. Additionally, or alternatively, the solid metal material may comprise an alloy with a metal, wherein the metal comprises at least one of tin, bismuth, indium, zinc, aluminum, lead, cadmium, lithium, thallium, gold, gold with a minor metal parts (< 12%) comprising silver, silver, copper, nickel, and other suitable metals.

The second block of Fig. 1 depicts that the method 100 further comprises applying 108 the molten metal material onto a polymer structure deformable by applying heat and/or pressure, wherein the molten metal material solidifies upon interacting (e.g. coming into contact) with the polymer structure so as to form metallic structures of customizable shape and structure. It should be noted that melting 104 of the solid metal material is carried out prior to applying 108 its molten form (i.e. the molten metal material) to the polymer structure.

The action of applying 108 may comprise depositing (for example, dispensing or ejecting), the molten metal material onto the polymer structure from a specific distance using a depositing means. It follows then that the depositing means may not establish a contact with the polymer structure during the application 108 of the molten metal material onto the polymer structure.

For example, the depositing means may be a printhead of a printing technology associated with the molten metal material, or may be a dispensing unit of a dispensing technology associated with the molten metal material. This specific distance may be kept stationary throughout the application 108, or alternatively, may even be varied during it. By this measure, an exposure time of the molten metal material, i.e. a time of transit of the molten metal material from the depositing means to the polymer structure, may be selected (e.g. controlled or manipulated).

In the case that the specific distance is varied, on the one hand the polymer structure may be moved in a predetermined (e.g. pre-programmed) manner while the depositing means may be kept stationary to perform the deposition, while on the other hand, alternatively, the depositing means may be moved in a predetermined (e.g. pre-programmed) manner while the polymer structure may be kept stationary to perform the deposition.

Further, applying 108 the molten metal material onto the polymer structure may be performed in a single stage. This single stage may be effected continuously, i.e. without interruptions, or alternatively, discontinuously, i.e. the single stage may comprise interruptions. Alternatively, applying 108 the molten metal material onto the polymer structure may be performed using a sequence of stages. It is feasible that stages among the sequence of stages may be performed in coordination with each other, and/or as per a predetermined procedure such as an algorithm.

Further, the action of applying 108 may comprise applying the molten metal material onto the polymer structure so as to obtain one or more arrangements of the solidified molten metal material onto the polymer structure.

The method 100 may comprise applying 108 (e.g. spraying or dispensing) the molten metal material as substantially small units of the molten metal material. The dispensed substantially small units of the molten metal material may comprise one or more droplets comprising a specific droplet diameter, or one or more streams comprising a specific stream diameter, or combinations of both. In particular, at least one of the specific droplet diameter and the specific stream diameter may range from a few µm to a few hundred µm. For example, at least one of the specific droplet diameter and the specific stream diameter may range from 30 µm to 1000 µm. Further, the one or more droplets and/or the one or more streams may be sprayed or dispensed with a specific velocity comprising a range from 0.1 m/s to 5 m/s.

The method 100 may comprise applying 108 the molten metal material onto the polymer structure by the use of an opening, for example, an aperture or an orifice. A size of the opening may be adapted to manipulate (i.e. obtain as desired) physical characteristics of the one or more droplets and/or the one or more streams. A cross-section of the opening may comprise at least one of a circular shape, a square shape, a rectangular shape, and a polygonal shape. For example, the cross-section of the opening may be adapted to obtain the specific droplet diameter and/or the specific stream diameter.

It is noted that applying 108 the molten metal material onto the polymer structure may be performed using an actuation mechanism. For example, the actuation mechanism may be based on any of mechanical, electromagnetic, electrical, capacitive, ultrasonic, and hydraulic principles, whilst not excluding combinations of the aforementioned principles and not limiting other suitable actuation mechanism principles.

Specifically, according to some embodiments, the method 100 may further comprise applying the molten metal material as microdroplets and/or jets onto the polymer structure from the specific distance, preferably by applying the molten metal material onto the polymer structure through a nozzle. That is, the opening may comprise the nozzle. For example, a nozzle diameter may comprise a range from 10 µm to 1000 µm. According to some preferred embodiments, the method may comprise applying the molten metal material onto the polymer structure through the nozzle comprising a star-shaped opening. For instance, the physical characteristics of the microdroplets and/or the jets may be controlled by modifying the nozzle For instance, size of the microdroplets and/or the jets may be controlled by adjusting any of the nozzle diameter and a number of nozzle channels and their widths.

For example, the method may further comprise applying (e.g. depositing) the molten metal material onto the polymer structure using StarJet technology.

In accordance with the present inventive concept, the method 100 of Fig. 1 benefits from a large range of polymers that it allows to be used. The method 100 overcomes the shortcoming of needing a careful selection of polymers, as is the case for methods involving conductive inks and pastes.

In accordance with embodiments, the polymer structure may have a melting point in a range between 50° - 500° C. For example, the melting point of the polymer structure may be at least 50° C, or at least 55° C, or at least 60° C, or at least 65° C. Thus, the method 100 allows utilizing polymers with relatively lower melting points for the manufacturing of the product.

It is noted that the polymer structure is deformable by applying heat and/or pressure to it. This means that the polymer structure may be adapted to change its shape and its structure upon the application of heat and/or pressure. Additionally, or alternatively, the polymer structure may also be deformable by applying force (e.g. mechanical force) to it. Thus, the polymer structure may obtain a deformed shape and a deformed structure in response to the heat and/or the pressure and/or the force. This means that the polymer structure may remain deformed even when the heat and/or the pressure and/or the force is no longer applied. It is to be noted that the polymer structure may exhibit the deformed shape and the deformed structure without enduring structural damage (defects).

For example, the polymer structure may be stretchable and/or compressible. For instance, the polymer structure may be torsionable or twistable, i.e. allow itself to be twisted without developing structural defects. Although the polymer structure may be stretched along a multitude of directions, it is feasible that the polymer structure allows being stretched along one or more preferred stretching directions.

Further, the method 100 provides an improved electrical performance. For example, the electrical conductivity of the formed metallic structures may only reduce by just 50% after applying strain i.e. after thermo-forming, in contrast to around a few 100 times which is the case for printed inks

It is even feasible in scenarios the polymer structure may exhibit a degree of elasticity, that is, the polymer structure may deform under the application of heat and/or pressure and/or force, but may regain its original shape and structure when the heat and/or the pressure and/or the force is removed. In other words, the polymer structure may deform in a transitory manner.

It is preferable that the polymer structure may comprise cyclic olefin copolymer, COC. In the following, we provide a number of non-limiting examples of which the described polymer structure may be comprised of. It is noted that the following examples do not preclude or restrict other suitable polymers generally known to persons skilled in the art. Thus, for example, additionally or alternatively, the polymer structure may comprise any of polycaprolactone i.e. PCL, polyvinyl chloride i.e. PVC, polyethylene terephthalate i.e. PET, polyethylene naphtahalate i.e. PEN, polycarbonate i.e. PC, polyetheretherketone i.e. PEEK, polyimide i.e. PI, polyetherimide i.e. PEI, cyclic olefin polymers (COP), Poly(methyl methacrylate) i.e. PMMA, Polylactic acid i.e. PLA, Polyamide i.e. PA, Polypropylene i.e. PP, Polystyrene i.e. PS, Polyethylene i.e. PE, Acrylonitrile butadiene styrene i.e. ABS, polyethersulfone i.e. PES, silicone, polydimethylsiloxane i.e. PDMS. Heat stabilized versions of the aforementioned exemplary polymers may also be used.

As a consequence of applying 108 the molten metal material onto the polymer structure, the method 100 proceeds with the molten metal material solidifying upon coming into contact with the polymer structure. After the molten metal material interacts with the polymer substrate, it may effect relatively minor alterations of surface of the polymer structure. That is, for example, the molten metal material may transfer energy in the form of heat and bend the surface of the polymer substrate upon coming into contact (i.e. touching) it.

The molten metal material cools down and hardens once contact with the polymer structure is established. This means that temperature of the molten metal material is lowered than its melting point during this phase change i.e. during solidification.

In accordance with some embodiments, the solidified molten metal material may be sunken into the polymer structure. This sinking of the solidified molten metal material may be brought about due to an effect of gravity as the molten metal material solidifies and/or due to an outcome of inter-molecular forces between the molten metal material and the polymer structure. In other words, the solidified molten metal material may partially penetrate the polymer structure during the solidification.

As the molten metal material hardens and becomes solid, i.e. when the solidification is achieved, the solidified molten metal material is compressed in the polymer structure thereby forming the metallic structures. That is, the metallic structures result from the molten metal material undergoing a change in size (e.g. a volumetric contraction) owing to the solidification. In accordance with what has already been explained, the surface of the polymer substrate may be deformed (e.g. warped, or bent) in a substantially minor (e.g. minor) manner when compared to an overall size of the polymer substrate during the course of the solidification.

Further, for a particular volume of the molten metal material, a time period associated with the solidification, i.e. a time required for the molten metal material to cool down, may be relatively short, especially when compared to conventional techniques related to printed (conductive) inks such as sintering, or curing. For example, for a droplet, the time period associated with the solidification may be less than 100 ms. This time period associated with the solidification may depend on the particular volume of the molten metal material and thus, is subject to variations arising from values of the particular volume.

It is especially noted that in conjunction with the solidification, both the molten metal material and the solidified molten metal material interact with the polymer structure so as to obtain a substantially adhesive connection along the points of contact (e.g. between their respective outer surfaces). This may be due to localized nature of a thermal impact created (during applying 108) on the polymer structure which supports the intermolecular interactions for adhesion. As a result, the metallic structures may be rendered substantially immobilized, improving fixture of the metallic structures to the polymer substrate.

Further, since the molten metal material may be applied 108 onto the polymer structure according to the one or more arrangements upon preference, the metallic structures formed thus are of customizable shape and structure. Examples and embodiments comprising such one or more arrangements will be described afterwards in the disclosure. Although the solidification proceeds substantially quickly and automatically, it can be supported. For instance, some variations of the method 100 may further comprise using cooling means to the molten metal material as it solidifies so as to quicken the solidification.

Further, the polymer structure may be fabricated using additive manufacturing technologies. Such technologies may comprise, for example, fused deposition modeling (FDM) or fused filament fabrication (FFF) process, whilst not excluding other additive manufacturing technologies. By this measure, the polymer structure may be fabricated so as to obtain insulation. Additionally or alternatively, this fabrication of the polymer structure may be performed in a layer-by-layer manner. For example, as an optional feature, the aforementioned additive manufacturing technologies may not be restricted to merely form insulating layers.

The third block of Fig. 1 depicts that the method 100 further comprises three-dimensional deforming 112 the polymer structure including the metallic structures by providing heat and/or pressure to the polymer structure including the metallic structures so as to obtain a specific shape. That is, the polymer structure and the metallic structures are deformed 112 together, i.e. as a joined (e.g. merged) structure, to obtain the specific shape. Thus, in accordance with some embodiments, the three-dimensional deforming 112 may be performed so that the metallic structures and the polymer structure having the specific shape are conformally formed.

The three dimensional deforming 112 may be performed on only one outer surface of the polymer structure including the metallic structures (or equivalently, the joined structure) to obtain the specific shape. Additionally, or alternatively, the deforming 112 may be performed on more than one outer surface of the polymer structure including the metallic structures (or equivalently, the joined structure) to obtain the specific shape.

The specific shape may comprise any planar, or 2D, shape. Additionally or alternatively, the specific shape may comprise a 3D shape (e.g. a complex 3D shape).

It is to be understood that the metallic structures formed using the method 100 are electrically conductive. Thus, the metallic structures may be used to provide one or more electronic functions and/or one or more photonic functions.

In accordance with some embodiments, the method 100 may further comprise applying one or more electronic and/or photonic components onto the polymer structure and interconnecting the metallic structures and the one or more electronic and/or photonic components before or after the three-dimensional deforming 112 of the polymer structure. It should be noted that the three dimensional deforming 112 is carried out after applying 108 the molten metal material onto the polymer structure.

For example, the one or more electronic and/or photonic components may be arranged onto the polymer structure using pick-and-place/surface mount device, SMD, technology. That is, equivalently, the one or more electronic and/or photonic components may comprise SMD components.

It is feasible that the metallic structures and the one or more electronic and/or photonic components may be interconnected using conventional soldering technology. Alternatively, however it is also feasible that the metallic structures and the one or more electronic and/or photonic components may be interconnected by melting 104 the solid metal material to the molten metal material and applying the molten metal material onto the one or more electronic and/or photonic components, wherein the molten metal material solidifies upon coming into contact with the one or more electronic and/or photonic components form to form solder structures of customizable shape and structure. That is, some of the metallic structures may comprise solder structures for interconnecting other metallic structures and the one or more electronic and/or photonic components.

Possibly, the one or more electronic and/or photonic components may comprise pre-fabricated components. For example, the pre-fabricated components may comprise at least one of sensors, resistors, inductors, accelerometers, gyroscopes, electrodes, heaters, LED, electrical circuitry, IC chips, printed circuit boards or parts thereof, displays, touch bottoms and antennas.

Additionally, or alternatively, the one or more electronic and/or photonic components may even be fabricated using the method 100 as depicted in Fig. 1. In other words, the method 100 may comprise structuring a number (e.g. at least one) of the metallic structures as the one or more electronic and/or photonic components.

In accordance with some embodiments, the method 100 may further comprise covering the metallic structures by a covering polymer layer or by over-molding with an over-molding polymer either prior to or after the three-dimensional deforming of the polymer structure. By this measure, the metallic structures, and/or the one or more electronic and/or photonic components if present, may be sealed, which may provide further structural stability and protection against possible external damage. The encapsulation provided by the covering polymer layer or by the over-molding may still allow additional structures and components, such as additional metallic structures and additional electronic and/or photonic components, to be applied afterwards.

The covering polymer and/or the over-molding polymer may comprise a same material as that of the polymer structure, or may comprise any of the polymers that the polymer structure may be comprised of, such as the ones stated earlier in the disclosure. Thus, it may be that the covering polymer, the over-molding polymer and the polymer structure may comprise different materials. Additionally, or alternatively, the covering polymer and/or the over-molding polymer may comprise polymers having relatively low viscosity, in comparison to the polymer structure.

According to some embodiments, the method 100 may further comprise providing the heat and/or the pressure to the metallic structures using at least one mold, wherein the at least one mold is configured to provide the specific shape. This means that the at least one mold comprises a negative (i.e. inverse) image/print of the specific shape. By this measure, the metallic structures may be cast into the specific shape using the at least one mold, and thus the specific shape may be provided to the product. For instance, the three-dimensional deforming may comprise the just-described molding, or alternatively, the just-described molding may be carried out after the three-dimensional deforming.

In accordance with some embodiments, the three-dimensional deforming 112 may comprise thermo-forming or hot embossing.

In accordance with some embodiments, the three-dimensional deforming 112, for instance, the thermo-forming/thermal forming, may be adapted to obtain (e.g. create) the specific shape as customized 3D shapes. The specific shape, in particular the customized 3D shapes, may be tailored for specific applications, such as fitting into irregular or space-constrained enclosures in automotive or consumer electronics.

In some scenarios, it may be feasible that during thermo-forming, the metallic structures including the polymer structure are subjected to a thermo-forming temperature higher than the melting point of the solid metal material that the metallic structures are comprised of. Therefore, the thermoforming may comprise melting the metallic structures so as to reshape them and obtain a further specific shape.

Alternatively, in some other scenarios, it may also be feasible that during thermo-forming, the metallic structures including the polymer structure are subjected to the thermo-forming temperature lower than the melting point of the solid metal material that the metallic structures are comprised of. Therefore, the thermoforming may comprise melting the metallic structures so as to further sink them into the polymer structure. In particular, this melting is in addition to the melting 104 described earlier, and therefore may be considered as a remelting, although this melting differs from the one 104 described earlier in the regard that here the melting relates to providing sufficient heat to only melt a part of the metallic structures without superheating it. It should be noted that in these scenarios, the (overall) specific shape obtained by the metallic structures including the polymer structure may be maintained, or alternatively, further shaped as desired.

The metallic structures and the polymer structures may thus be remelted after three-dimensional deforming 112. Further, the metallic structures and the polymer structures may be further subjected to a smoothing. Thus, the smoothing may provide the manufactured product with a better surface finish. In other words, in accordance with embodiments, the three-dimensional deforming may enhance surface finish by remelting and smoothing the polymer and/or metallic structures, thereby improving mechanical integrity and aesthetic quality of the polymer (including the metallic structures if applicable) structure, and hence the product.

It is noted that the one or more electronics and/or photonic components may be arranged so as to be embedded fully. Alternatively, the one or more electronics and/or photonic components may be arranged on at least one outer surface of the polymer structure and the metallic structures. For example, sensors and electrodes can be fully embedded or on the surface for interaction.

For instance, the method 100 may further comprise using an airflow to aid the solidification of the molten metal material. For instance, the method 100 may be performed in an environment filled with inert gases, thus providing a controlled environment for manufacturing the product.

It is emphasized that in accordance with embodiments, a plurality of solid metal materials i.e. different metal materials may be used, either taken individually or in combinations, for forming the metallic structures and/or the further metallic structures. The metal material of the metallic structures and/or the further metallic structure may be selected from the plurality of solid metal materials, wherein the corresponding metallic structure and/or corresponding further metallic structure is selected and adapted for providing a specific function. By this measure, the product may comprise different metallic structures differing in terms of their customizable shapes and structure in addition to their material compositions.

For example, metal materials comprising low melting points may be selected for forming the metallic structures and/or further metallic structures as electrical contacts and pads providing a smoothing effect whereas metal materials comprising high melting points may be selected for for forming the metallic structures and/or further metallic structures such as finer pitch interconnections providing stable shape fidelity).

The method 100 according to Fig. 1 manufactures the product. By virtue of the electrically conductive nature of the metallic structures (and possibly of the polymer structure, if electrically conductive), the product manufactured by the method 100 comprises one or more electronic functionalities. For instance, the product may be 3D-shaped objects with embedded electronic functions.

The following illustrates a number of non-limiting examples of products that may be manufactured using the method 100. It is emphasized that the following examples do not preclude or restrict other suitable digital apparatuses known to persons skilled in the art of electronics. The product may relate to a variety of fields such as, for example, integrated 3D electronics, integrated 3D housings, automotive interiors, household appliances, medical devices, aerospace, wearable electronics.

Further, it is possible parts, or steps, of the method 100 may be carried out in an automated manner. It is even feasible that the method 100 may be carried out entirely in an automated, i.e. the method 100 may be fully automated.

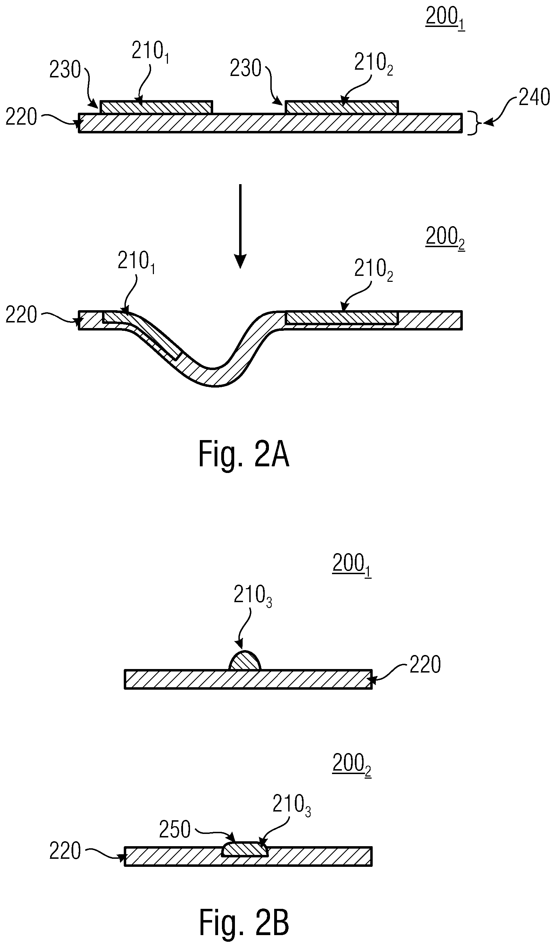

For example, in accordance with embodiments, the product comprising the polymer structure or the polymer layers and the metallic structures may be manufactured purely through additive manufacturing technology, for example, 3D printing. In particular, for example, it is noted that any further embodiments described later in the disclosure, including ones described by Figs. 2 to 6, may naturally also be manufactured purely through additive manufacturing technology, for example, 3D printing.

After having described an embodiment of the present inventive concept with respect to Fig. 1, the present application proceeds with descriptions of various figures illustrating different states that may be reached upon in the course of manufacturing products in accordance with embodiments.

Figs. 2a-b exemplarily show a schematic diagram of an implementation of the method 100 as described in Fig. 1. In particular, Fig. 2a exemplarily shows a cross-sectional view of two states 200₁, 200₂ of the implementation of the method 100 while Fig. 2b shows a detailed cross-sectional view corresponding to the two states 200₁, 200₂ depicted in Fig. 2a.

In the first state 200₁ of the implementation, two metallic structures 210₁, 210₂ are formed onto the polymer structure 220. The metallic structures 210₁, 210₂ comprising the solidified molten metal material may be formed after the molten metal material is applied onto the polymer structure 220. The state 200₁ shows these metallic structures 210₁, 210₂ after the solidification, that is, after the phase change of the applied molten metal material is completed.

Both the metallic structures 210₁, 210₂ and the polymer structure 220 are depicted as layers, and thus the state 200 shows a multi-material structure comprising two different layers. Specifically, as seen in Fig. 2a, the first metallic structure 210₁ and the second metallic structure 210₂ are arranged with a spatial separation between them onto the polymer structure 220.

For instance, each of the metallic structures 210₁, 210₂ as shown may be an electrical conductor track 210₁, 210₂ and each of the electrical conductor tracks 210₁, 210₂ may comprise a linewidth 230 ranging between 10 and 1000 µm within a tolerance range, while the polymer structure 220 may comprise a thickness 240 ranging from 10 µm up to, but not limited to, 1000 µm.

Fig. 2a additionally shows the second state 200₂ is obtained from the first state 200₁ by means of an arrow. This means the second state 200₂ of the implementation may be reached by either a single step, or a sequence of steps, performed relative to the first state 200₁.

The second state 200₂ shows that the metallic structures 210₁, 210₂ and the polymer structure 220 together comprise the specific shape, which is reached upon by three-dimensional deforming of the metallic structures 210₁, 210₂ and the polymer structure 220 of the first state 200₁. This means that the structures 210₁, 210₂, 220 may be subjected to thermo-forming or hot embossing to deform three-dimensionally to obtain the (overall) specific shape. In contrast to the state 200₁, here in the state 200₂ the metallic structures 210₁, 210₂ are sunken, or for example, merged or compressed, into the polymer structure 220. A detailed view of such merging/flattening/compression, or the like, is provided in Fig. 2b.

In particular, the first metallic structure 210₁ is deformed to comprise a partially curved shape while the second metallic structure 220 is deformed to roughly maintain its earlier straight shape (as in the state 200₁). The spatial separation between the two metallic structures 210₁, 210₂ has undergone a relatively more apparent deformation. This spatial deformation in the state 210₂ is greater than the one earlier, and comprises a curved shape. Specifically, the first metallic structure together with the spatial separation comprises a curved U-shape. It should be noted that it is feasible that only a portion of the structures in 200₁ may be subjected to three-dimensional deforming instead of the whole. For instance, the state 200₂ may be arrived at by deforming only the first metallic structure 210₁ and the spatial separation. It is also feasible that in addition to the deforming, the specific shape may be obtained by providing heat and/or pressure using the at least one mold, wherein the at least one mold is configured to impart the specific shape, such as the partly curved and party straight shape shown in the state 200₂.

Fig. 2b shows the state 200₁ corresponding to metallic structure 210₃ formed on the polymer structure and the state 200₂ corresponding to the metallic structure 210₃ being merged or sunken into the polymer structure. The merging or sinking as shown may comprise the polymer structure 220 surrounding or covering the metallic structure 210₃ along a plurality of surfaces. This means that the merging may proceed in a manner so that at least one surface 250 of the metallic structure 210₃ may not be covered by the polymer substrate 220. In other words, the polymer structure 220 may not adhere to along the at least one surface 250 of the metallic structure 210₃. Naturally, the nature of merging/sinking applies to more than one metallic structure, in accordance with Fig. 2a.

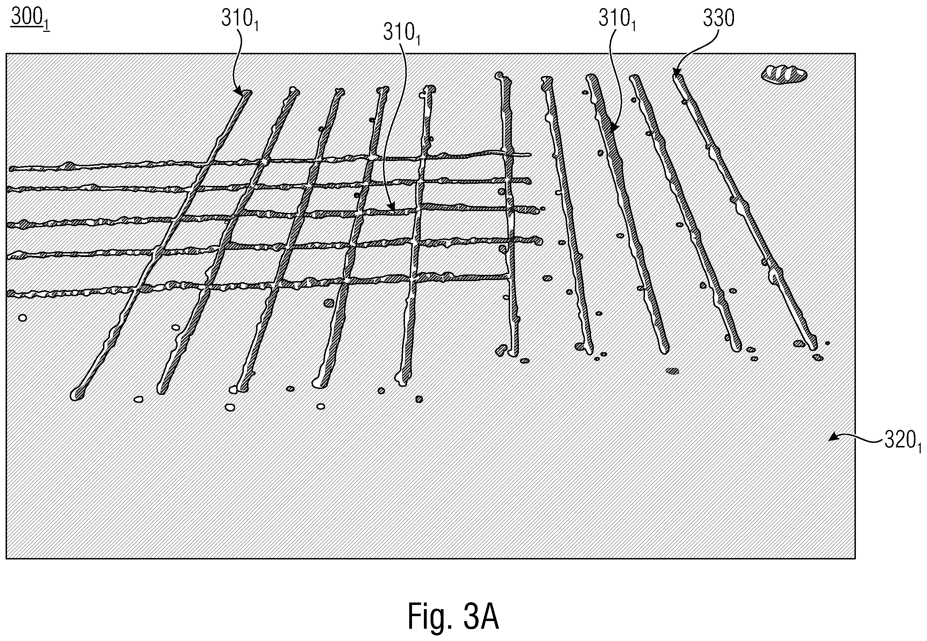

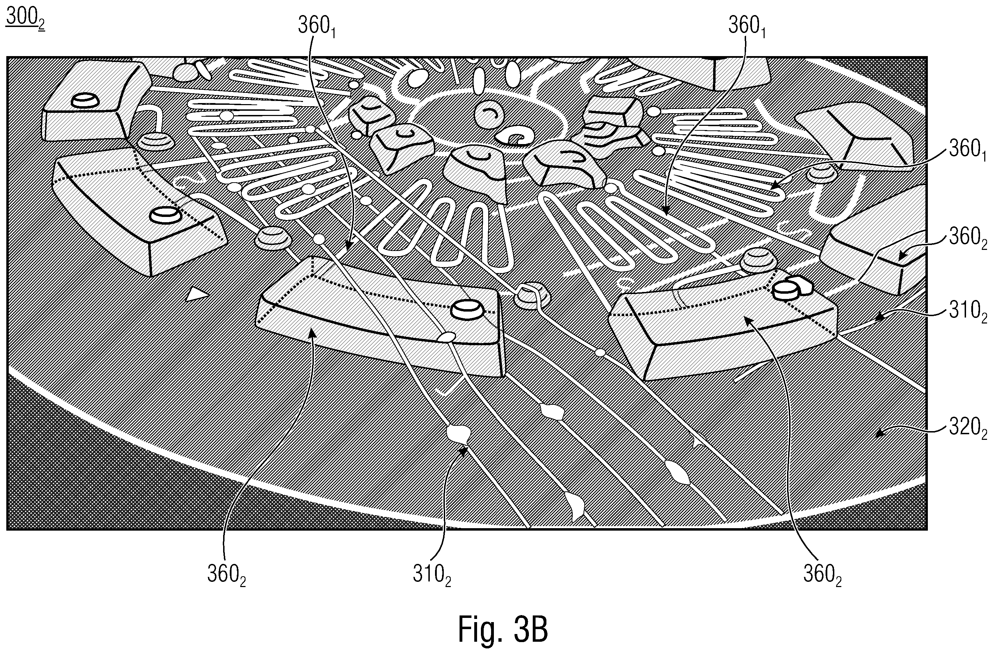

The present application proceeds further by describing different implementations of the product in Figs. 3 to 6 using varying realizations of the method according to Fig. 1.

Figs 3a-b show schematic illustrations of two states 300₁, 300₂ of manufacturing a product using the method in accordance with embodiments, respectively. For instance, the product may comprise a labdisk comprising integrated electrodes and/or sensors.

The state 300₁ shown in Fig. 3a is reached upon applying (e.g. printing) the molten metal material onto the polymer structure 320₁ i.e. a polymer foil 320₁. This is performed in a manner so that the metallic structure 310₁ is formed on the thin polymer foil 320, and comprises metal lines and grids, as shown in Fig. 3a. In other words, the shape and structure of the molten metal material is customized as metal lines and grids. In particular, the metal lines and grids as shown may be electrical conductor tracks 310₁.

For example, the metallic structure 320₁ may comprise metal alloy 57Bi-42Sn-1Ag comprising a melting point ranging between 137-139° C. For example, the metal alloy 57Bi-42Sn-1Ag may be melted at a melting temperature of 320° C using the melting apparatus, wherein the melting apparatus comprises, for instance, a reservoir of the StarJet printhead. It should be noted that this melting temperature is much higher than the melting point of the metal alloy 57Bi-42Sn-1Ag, and may not result in a damage of the polymer foil.

As already described in the present disclosure, in contrary to conventional technology such as metal nanoparticles dispersed in the ink or paste form, the solid metal material is directly deposited in the molten form (e.g. by melting at the melting temperature higher than the melting point of the metal material), the molten metal material becomes solid by phase changing as it gets cooled down after applying i.e. during the deposition process.

The metal material of the metallic structure 310₁, for instance the tin alloys including the metal alloy described previously, has relatively good flexibility during thermo-forming under heat and/or pressure. Thus, the metallic structure 310₁ may take the shape of the at least one mold and form conformal 3D structures together with the polymer structure 320₁.

For instance, each of the metal lines (i.e. electrical conductor tracks) 310₁ comprises a specific linewidth 330 ranging between 10 µm and 1000 µm within a tolerance range.

For example, the polymer foil 320₁ may comprise a thickness of 200 µm. For example, the polymer foil 320₁ may comprise cyclic olefin copolymer, COC.

The state 300₂ shown in Fig. 3b is reached upon three-dimensional deforming the polymer foil 320₁ and the metallic structure 310₁. While the 3D deforming may comprise thermo-forming or hot-embossing, the state 300₂ is obtained by thermo-forming the formed metal lines 320₁ and grids 320₁ along with the polymer foil 320₁ using the at least one mold. The at least one mold may be configured to provide the metallic structure 310₁ and the polymer foil 320₁ with microfluidic structures 360₁, 360₂. That is, the at least one mold may comprise a negative image of the microfluidic structures 360₁, 360₂. This explains the shape and structure of the polymer foil 320₁ as shown in Fig. 2b. It can be clearly seen that the polymer structure 320₁ including the metallic structure 310₂ now comprises a plurality of channels 360₁ and a plurality of reservoirs 360₂ as the microfluidic structures. For example, the at least one mold may comprise PDMS.

The metal lines 310₂ and grids 310₂ may not be re-designed to fit the at least one mold to test the flexibility and reliability of the metallic structure. High adhesion between the metallic structure 310₂ and the polymer foil 320₂ is achieved and thus, as seen in Fig. 3b, the metal lines 310₂ and grids 310₂ follow conformally with the 3D deformed and molded polymer foil 320₂.

For example, a peak thermo-forming temperature among the thermo-forming temperatures that the metal lines and grids are subjected to may be 160° C. Therefore, the thermo-forming temperature (e.g. 160 °C) may be higher than the melting point of the metal material (e.g. 137-139 °C for 57Bi-42Sn-1Ag), and the metal lines 310₂ may be partly remelted, flattened (re-shaped), and smoothed during the thermo-forming process.

Alternatively, in the case of thermo-forming temperature (e.g. 160 - 180 °C) is lower than the melting point of the (printed) metal material (e.g. 217 °C for 96.5Sn-3.5Ag-0.5Cu or SAC305 in abbreviation), the original line shape (as obtained after applying the molten metal material onto the polymer structure and solidifying) may be maintained, but the metallic structure (i.e. the whole structure) may be sunken (e.g. pushed or merged) into into the polymer foil.

With respect to reaching upon the state 300₂, the (bulk) electrical conductivity of the solid metal material (e.g. bulk metal) is achieved and thus, a relatively high electrical conductance is maintained after thermo-forming.

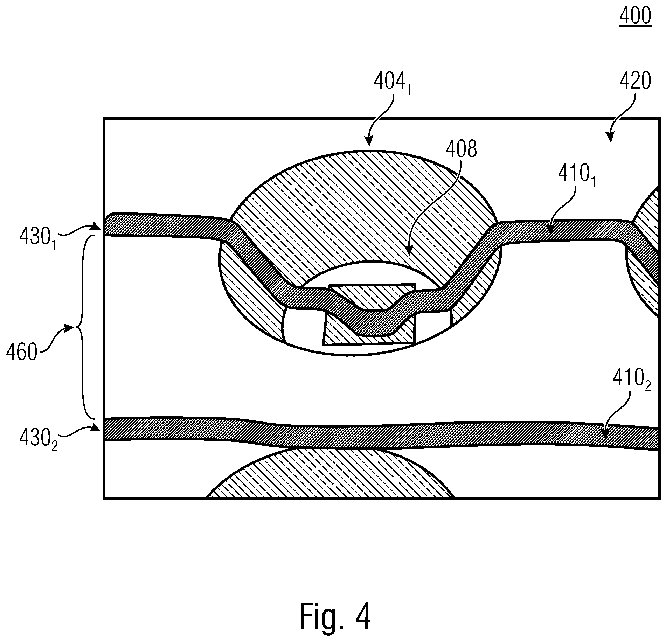

Figure 4 exemplarily shows a schematic illustration of a product 400 as manufactured using the method in accordance with embodiments.

As shown, the product 400 is a well-plate array, which may comprise a plurality of well-plates. In particular, one well-plate 404₁ of the plurality of well-plates can be clearly seen. The one well-plate 404₁ comprises a recess 408₁ having an electrical conductor track 410₁ passing through it. The recess 408₁ comprises a circular shape.

The well-plate array 400 is implemented on the polymer structure 420 comprising a plurality of recesses including the recess 408₁. Another electrical conductor track 410₂ passes through a non-recess region of the polymer substrate 420 and near a recess neighboring the recess 408₁.

In the following, the realization of the product i.e. well-plate array 400 in accordance with the method(s) of the present disclosure is described.

Molten metal material may be applied onto the polymer substrate 420, for example, a polymer foil. This polymer foil 420 may already be deformed (i.e. by applying heat and/or pressure) to partly or wholly comprise the plurality of recesses. Additionally, or alternatively, the polymer foil 420 may not be deformed and may comprise a flat surface. The molten metal material may be applied so as to form the metallic structures (after solidifying) as the electrical conductor tracks 410₁, 410₂, each of which comprises a specific linewidth 430ᵢ. The specific linewidths 430 of the electrical conductor tracks may range between 10 µm and 1000 µm within a tolerance range. Further, the application of the molten metal material may be performed in a manner so that the electrical conductor tracks are parallel to each other and comprise a spacing 460 between them. For example, this spacing 460 may be 9 mm.

In the scenario wherein the polymer foil 420 may already comprise the plurality of recesses, at least one of the electrical conductor tracks 410₁, 410₂ may pass through at least one of the plurality of recesses. The polymer foil 420 and the electrical conductor tracks 410₁, 410₂ may be 3D deformed so as to obtain the specific shape and so that the electrical conductor tracks 410₁, 410₂ are merged into the polymer foil 420 as shown in Fig. 4.

In the scenario wherein the polymer foil 420 may not yet comprise the plurality of recesses, the polymer foil 420 and the electrical conductor tracks 410₁, 410₂ may be 3D deformed (i.e. compressed, and/or stretched, and/or twisted) so as to obtain the specific shape. That is, heat and/or pressure may be applied to the foil 420 and the electrical conductor tracks 410₁, 410₂ to form the plurality of recesses. It is noted that the plurality of recesses may be formed using at least one mold. The one mold may comprise a negatively imaged structure of the plurality of recesses so as to provide the specific shape, as shown in Fig. 4, when contact is established with the polymer foil 420 and the electrical conductor tracks 410₁, 410₂. In the course of using the one mold, the electrical conductor tracks 410₁, 410₂ may also be sink into, or merge within, the polymer foil 420.

Further, a depth of the recesses formed by deforming and/or using the mold may be controlled. For example, the depth of the recesses may be 11 mm.

The well plate array 400 can be used to perform impedance measurements of biological systems such as cell cultures, in particular, organoids, cells, or spheroids, whilst not excluding other suitable biological systems or model systems.

For example, the well plate array 400 may comprise 96 well-plates.

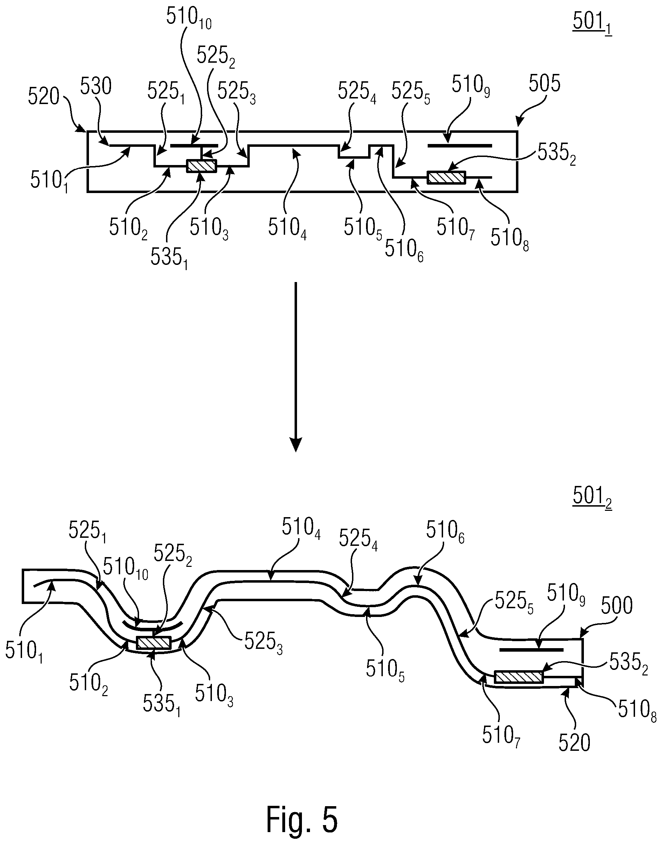

Fig. 5 exemplarily shows a schematic illustration of a product 500 as realized using the method according to Fig. 1 and variations thereof. The product 500 is a three-dimensionally conformable printed circuit board i.e. 3D-conformable PCB.

In particular, Fig. 5 shows a cross-sectional view of two states 501₁, 501₂, which may be successively performed one after another as indicated by the arrow whilst not excluding additional possible states, comprised by the method of manufacturing the product 500. In the first state 501₁, a multi-layer PCB 505 is depicted. In the second state 501₂, the multi-layer PCB 505 after three dimensional thermal deforming is depicted.

The multi-layer PCB 505 as a multi-layer structure comprises the metallic structures as (horizontal) electrical conductor tracks, indicated by solid horizontal lines 510₁, 510₂, 510₃, 510₄, 510₅, 510₆, 510₇, 510₈, 510₉, 510₁₀, a plurality of polymer layers, which are altogether depicted as a box 520 (and including the polymer housing). in Fig. 5, and further metallic structures indicated as (vertical) electrical conductor tracks by vertical solid lines 525₁, 525₂, 525₃, 525₄, and two electronic and/or photonic components 535₁, 535₂ which are depicted using dashed boxes. It is noted that "vertical" and "horizontal" nature of the electrical conductor tracks may be defined in relation to the polymer layers. For example, vertical electrical conductor tracks may be conductor tracks extending in a direction perpendicular to a plane formed by (primary) surfaces of the polymer layers, or (primary) outer surface of the polymer structure whereas horizontal electrical conductor tracks may be conductor tracks extending in a direction parallel to a plane formed by (primary) surfaces of the polymer layers, or (primary) outer surface of the polymer structure. This exemplary definition of vertical and horizontal tracks may be readily applied to other embodiments and details presented in this disclosure.

In accordance with Fig, 5, the metallic structures 510₁ ... 510₁₀ are formed on four different polymer layers. This is indicated in the state 501₁ since the metallic structures 510₁ ... 510₉ are arranged in four different vertical positions.

The metallic structures 510₇, 510₈ the electronic and/or photonic component 535₂ comprise the first vertical position and are thus formed on the first polymer layer. Further, the metallic structures 510₇, 510₈ are both connected to the electronic and/or photonic component 535₂. The metallic structures 510₂, 510₃ and the electronic and/or photonic component 535₁ comprise the second vertical position (vertically higher than the first vertical position) and are thus formed on the second polymer layer. Further, the metallic structures 510₂, 510₃ are both connected to the electronic and/or photonic component 535₁. The metallic structure 510₅ comprises the third vertical position (vertically higher than the second position) and is thus formed on the third polymer layer. The metallic structures 510₁, 510₄, 510₆, 510₉, 510₁₀ comprises the fourth vertical position (vertically higher than the second position) and is thus formed on the fourth polymer layer.

The further metallic structure 525₁ interconnects the metallic structures 510₁, 510₂ between the second and the fourth polymer layer. The further metallic structure 525₂ interconnects the metallic structures 510₁₀ of the fourth polymer layer with the electronic and/or photonic component 535₁ of the second polymer layer. The further metallic structure 525₃ interconnects the metallic structures 510₃, 510₄ between the second and the fourth polymer layer. The further metallic structure 525₄ interconnects the metallic structures 510₄, 510₅ between the third and the fourth polymer layer. The further metallic structure 525 interconnects the metallic structures 510₆, 510₇ between the first and the fourth polymer layer.

In accordance with embodiments, for realizing the PCB 505, the method may comprise: providing the polymer layers, applying the molten metal material onto the corresponding polymer layer so as to form the metallic structures 510₁, ... , 510₁₀, applying the electronic and/or photonic component 535₁, 535₂ onto at least one of the plurality of polymer layers, wherein at least one of the metallic structures 510₁, ... , 510₁₀ is connected to the at least one electronic and/or photonic component 535₁, 535₂. For realizing the PCB 505, the method may further comprise: generating further metallic structures 525₁, ... 525₅ as vertical electrical conductor tracks 525₁, ... 525₅ interconnecting the corresponding metallic structures 510₁, ..., 510₁₀ formed on different polymer layers. This generation of the further metallic structures may be performed before or after three-dimensional deforming the multi-layer structure, i.e. the PCB 505.

Specifically, interconnecting may comprise applying the molten metal material between the corresponding metallic structures 510₁, ... , 510₁₀ formed on different polymer layers. For instance, this application of the molten metal material may be performed using hybrid 3D printing technology. For example, the hybrid 3D printing technology may comprise the StarJet technology.

Alternatively, interconnecting may comprise designing holes between the corresponding metallic structures 510₁, ... , 510₁₀ formed on different polymer layers and applying the molten metal material so as to fill them before or after before or after three-dimensional deforming the multi-layer structure, i.e. the PCB 505.

It may be that providing the plurality of polymer layers may be performed in a sequential manner with respect to each layer. For example, the plurality of polymer layers may be provided using a Layer-by-Layer, (LbL), printing technology such as fused filament fabrication, FFF, technology.

For example, each of the conductor tracks 510ᵢ comprises a specific linewidth 530 ranging between 10 µm and 1000 µm within a tolerance range. For example, each of the vertical electrical conductor tracks 525₁, ... 525₅ comprises a specific linewidth ranging between between 10 µm and 1000 µm within a tolerance range.

For example, the PCB 505 may comprise a 3D hybrid printed multi-layer PCB.

For instance, the electronic and/or photonic components may be provided using pick-and-place/surface mount device, SMD, technology. These electronic and/or photonic components may be connected to the polymer layers using traditional soldering technology, or alternatively, by applying the molten metal material onto the polymer layers, wherein the molten metal material solidifies upon coming into contact with the polymer layers so as to form solder structures.

The state 501₂ is reached from the state 501₁ by three-dimensional deforming, that is thermo-forming or hot-embossing the multi-layer PCB 505. Thus, in accordance with embodiments, for realizing the PCB 500, the method may further comprise three-dimensionally deforming the PCB 505 of the state 500₁.

The PCB 500 in the second state 501₂ comprises a complex deformed shape as the specific shape. As is clearly seen from Fig. 5, the polymer structure i.e. the plurality of layers, the metallic structures 510₁, ..., 510₁₀ and the further metallic structures together 525, , ... , 525₅ are conformally shaped. The configuration of the PCB 501₂ clearly illustrates that the PCB 500 is a bendable and 3D conformable electronic structure.

The metallic structures 510₁, ..., 510₁₀ may provide 2D, or planar, interconnections between the electronic and/or photonic components and the polymer layers as electrically conductive traces.

In particular, the further metallic structures 525₁ , ... , 525₅ provide interconnection (e.g. vertically conductive traces) between the plurality of polymer layers and may be formed into desired 3D shapes. This is difficult to achieve with conventional solutions, wherein multiple thin polymer films comprising printed electronics may be stacked.

The PCB 500 may even be further 3D-deformed so as to obtain another specific shape.

Further, the electronic and/or photonic components may be arranged so as to obtain a particular configuration or orientation. This may be difficult to achieve with conventional technology such as 3D printing.

Thus, 3D complex shaped flexible and conformable electronics such as the one 500 illustrated by Fig. 5 may be manufactured.

Further, according to some embodiments, the one or more electronic components and/or photonic components 535₁, 535₂ such as sensors may be arranged and soldered to the polymer structure 520 or the plurality of polymer layers using a pick and place system. The one or more electronic components and/or photonic components 535₁, 535₂ may be oriented during fabrication of the polymer structure 520 or the plurality of polymer layers to align with specific axes or angles for achieving improved, or possibly optimal, functional performance in the specific shape such as a final 3D shape, which is otherwise difficult to achieve with conventional 3D printing techniques. For example, one of the specific axes may be aligned in a direction perpendicular to primary outer surfaces of the polymer layers or the polymer structure while another of the specific axes may be aligned in a direction parallel primary outer surfaces of the polymer layers or the polymer structure. For example, the angles may be relative to polymer tracks (e.g. roads) of the polymer structure (e.g. wherein the polymer tracks, or roads, may be formed on outer surfaces of the polymer layers or the polymer structure) or the plurality of polymer layers.

Furthermore, the further metallic structures 525₁₋₅, for example, providing vertical interconnections and possibly formed between the plurality of polymer layers, may be generated during the fabrication of the plurality of polymer layers (e.g. directly fabricated during an additive manufacturing stage), reducing the need for post-processing steps such as drilling and filling, thereby improving manufacturing efficiency and electrical connectivity (e.g. possibly ensuring almost seamless electrical connectivity).

Figure 6 exemplarily depicts a schematic illustration of a product 600 as implemented using the method according to Fig. 1 and variations thereof. The product 600 is a multi-layer stacked structure.

In particular, Fig. 6 shows a cross-sectional view of three states 601₁, 601₂, 601₃, which may be successively performed one after another as indicated by the arrow whilst not excluding additional possible states, comprised by the method of manufacturing the product 500. In the first state 601₁, two different structures 602₁, 602₂ are shown. The second state 501₂ shows the two structures 602₁, 602₂ in assembly, and the third state 601₃ shows the product 600 obtained upon the state 601₃ as a result of the two structures 602₁, 602₂ subjected to three-dimensional deforming.

The first structure 602, comprises the metallic structures 610₁, 610₂, 610₃, the polymer structure 620₁ and the electronic and/or photonic component 635₁, wherein the metallic structures 610₁, 610₂, 610₃ and the electronic and/or photonic component 635₁ are applied on the polymer structure 620₁. In particular, the metallic structures 610₁, 610₂ and the electronic and/or photonic component 635₁ are interconnected, while as shown in Fig. 5, the metallic structure 610₃ is not interconnected with the metallic structures 610₁, 610₂ and the electronic and/or photonic component 635₁. This interconnection may be performed either before or after three-dimensionally deforming of the structure 602_{1.}

The second structure 602₂ comprises the metallic structure 610₄ and the polymer structures 620₂, 620₃, 620₄, 620₅, wherein the metallic structure 610₄ are applied on the polymer structures 620₂, 620₃, 620₄.

The first 601₁ and the second structure 601₂ are arranged or assembled together as indicated in the second state 601₂. In particular, the second structure 601₂ is stacked together on top of the first structure 601₁.

The product 600 as indicated in the state 602₃ is finally obtained after three-dimensional deforming of the stacked structures 601₁, 602₂. This deforming may comprise thermo-forming or hot embossing the stacked structures 601₁, 602₂. As can be seen in Fig. 6, the product 600 comprises a complex 3D shape as the specific shape. The two structures 601₁, 601₂ of the previous states 602₁, 602₂ are merged into one another to form the product 600. Additionally, or alternatively, the product may be deformed prior to being molded (by applying heat and/or pressure) by the at least one mold to obtain the specific shape.

The product 600 may be further three dimensionally deformed to obtain a further specific shape. More structures may be stacked onto the product 600 and three-dimensionally deformed and/or molded as preferred.

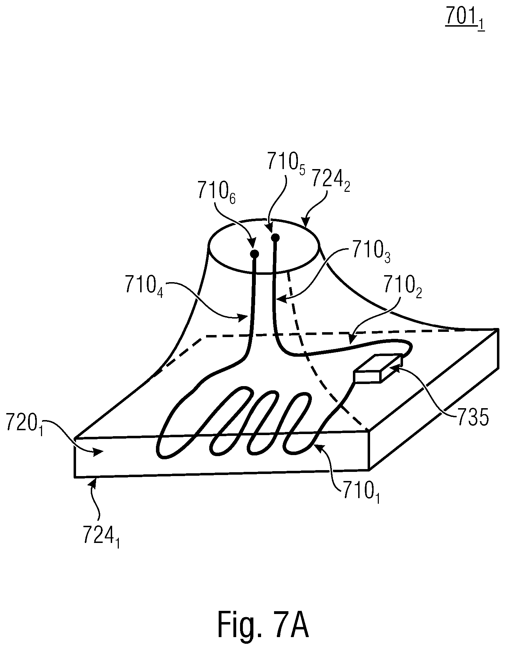

Figs. 7a-b exemplarily schematic illustrations of three states 701₁, 701₂, 701₃ of manufacturing a product 700 using the method in accordance with embodiments. The product 700 may comprise an integrated ear blood pressure sensor.

The state 701₁ shown in Fig. 7a is reached upon applying (e.g. printing, or depositing) the molten metal material onto the polymer structure 720₁. The polymer structure 720₁ may initially comprise at least a first surface 724₁ onto which the molten metal material is applied and forms the metallic structures 710₁ i.e. (planar) electrical conductor track 710₁ of customized shape and structure as shown in Fig. 7a. This customized shape and structure comprises a complex planar shape with curved portions.

Further, the electronic and/or photonic component 735₁ such as the sensor 735₁ may be applied onto the first surface 724₁ of the polymer structure 720₁ and the (planar) electrical conductor track 710₁ may be interconnected. Another metallic structure 710₂ i.e. the (planar) electrical conductor track 710₂ of customized shape and structure, which comprises a curved shape, as shown in Fig. 7a may be obtained by applying the molten metal material onto the first surface 724₁ of the polymer structure 720₁ and solidifying it. The (planar) electrical conductor track 710₂ may be interconnected to the sensor 735₁.

The polymer structure 720₁ may be provided the plurality of layers (and may be 3D-deformed) so as to finally obtain the obtain the multi-layer structure 720₁ comprising the specific shape i.e. the complex shape and structure in accordance with the state 701₁ shown in Fig. 7a. As a result, the polymer structure comprises a second surface 724₂. This second surface 724₁ comprises a smaller cross-section than that of the first surface and its plane may be parallel to that of the first surface 724₁. Together, the two surfaces 724₁, 724₂ indicate a vertical extension of the polymer structure 720, spanning from one of the surfaces 724₁, 724₂ to the other.

This shape and structure may be obtained as a result of 3D printing the polymer structure 720₁. The complex shape of the polymer structure 720₁ as shown comprises the first (outer) surface 724₁ having a free-form shape and the second (outer) surface 724₂ having a planar shape.

This printing of the polymer structure may be performed in a layer-by-layer manner. Further metallic structures 710₃, 710₄ i.e. (vertical) electrical conductor tracks 710₃, 710₄ may be generated. It can be seen from Fig. 7a that these tracks 710₃, 710₄ extend vertically away from the plane of the first surface 724₁, and interconnect the (planar) tracks 710₁, 710₂ across the plurality of layers to metallic structures 710₅, 710₆ formed on the second surface 724₂ of the polymer structure 720₁. The metallic structures 710₅, 710₆ as shown in Fig. 7a comprise electrodes 710₅, 710₆. Specifically, the electrode 710₅ is connected to the (vertical) conductor track 710₃ and the electrode 710₆ is connected to the (vertical) conductor track 710₄.

For instance, each of the conductor tracks 710₁, 710₂, 710₃, 710₄ comprises a specific linewidth 730ᵢ ranging between 10 µm and 1000 µm within a tolerance range. For instance, the electrodes comprise an electrode diameter ranging between 100 - 5000 µm.

The above description relates to an exemplary scenario of reaching the state 701₁. Other scenarios comprising variations to the above described scenario exist and may be comprised by embodiments of the method with respect to Figs. 7a-b.

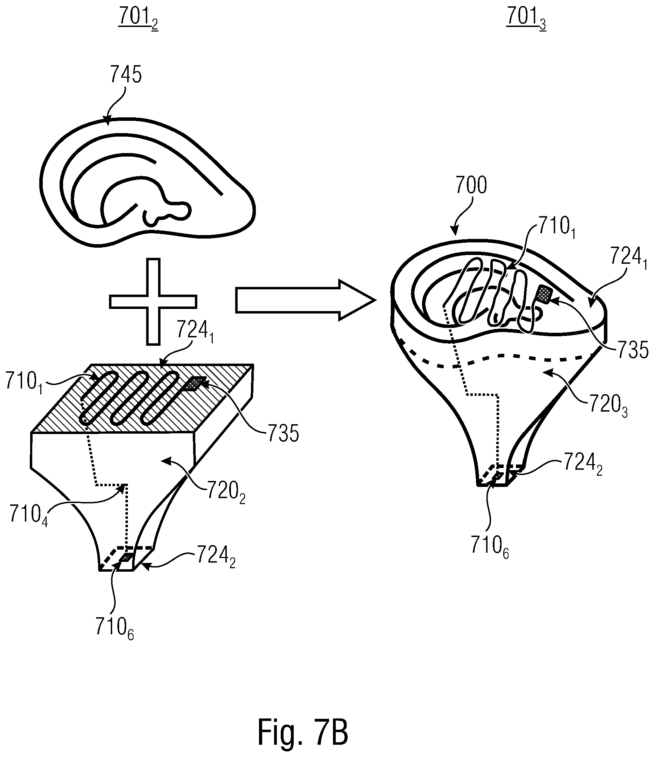

The state 701₂ of Fig. 7b depicts that a variation 720₂ of the 3D polymer structure 720₁ shown in Fig. 7a is subjected to a re-molding using the at least one mold 745. The mold 745 comprises a complex 3D shape relating to a human ear. It is noted that the mold 745 comprises a negative (inverse) image/print of a human ear. Although the polymer structure 720₂ is used here, the 3D polymer structure 720₁ may also be used without any variations in the state 701₂ for re-molding it. Hence, as shown in Fig. 7b, the polymer structure 720₂ does not comprise all features of the polymer structure 720₁. The solid line denotes the (planar) conductor track 710₁ on the first surface 724₁ while the dashed line denotes the (vertical) conductor track 710₄ inside the 3D body of the polymer structure 720₂. For instance, the polymer structure 720₂ may be 3D printed comprising inner porous structures for molding (e.g. low in-filling).

The re-molding of the 3D polymer structure 720₂ is performed on the first surface 724₃ of the polymer structure 720₂. This means that heat and/or pressure and/or force may be provided to the polymer structure 720₂ on its surface 724₃ using the mold 745. This re-molding may comprise, for example, stamping, or hot-embossing or even injection molding.

The state 701₃ is reached upon the re-molding according to the state 701₂. It is seen that the first surface 724 is not planar owing to the re-molding. In particular, the conductor track 710₁ now comprises a 3D conformally shaped metallic structure and the sensor 735 comprises a conformally angled sensor surface. Thus, both the metallic structure 710₁ and the electronic and/or photonic component i.e. the sensor 735 comprise the complex 3D shape provided by the mold 745 and thus, resulting in the product 700 as shown in Fig. 7b.

By this measure, the printed metallic structures such as electrodes 710₆ and/or conductive tracks 710₁ and the electronic and/or photonic components 735 can conformally comprise the complex shapes associated with the patient ear topology. In particular, the sensor 735 of the product 700 may (directly) measure blood pressure associated with a human ear without errors such as arising due to air gaps, or misplacement/misalignment, vibrations during movement, etc.

For example, in the application of producing an integrated ear blood pressure sensor via an individual ear plug fitting dedicated patent, the 3D printing cannot 100% replicate the human ear structure. With respect to the embodiments described by Figs. 7a-b, the contact area to the patient's ear may not be directly printed into the shape but can be kept as a planar surface (as exemplarily shown in Fig. 7a) and thermoformed subsequently.

In accordance with the invention, a product obtainable by a method, in accordance with embodiments, may comprise a polymer structure; one or more electronic and/or photonic components; metallic structures comprising a metal material, preferably, wherein the metallic structures are connected to at least one of the one or more electronic and/or photonic components; wherein the metal material of the metallic structures is sunken into the polymer structure; wherein the metallic structures and the polymer structure together are three-dimensionally deformed to obtain the specific shape are conformally formed: and wherein the metallic structures and the polymer structure having the specific shape are conformally formed.

According to embodiments, the metallic structures may comprise at least one electrical conductor track, preferably, comprising a linewidth ranging between 10 and 1000 µm.

It is noted that the above described product is obtainable by the method and various embodiments of the invention as already described in this disclosure. Therefore, explanations and features previously described in terms of a method and/or an object/device/component, either taken individually or combined with each other, are transferable and combinable to the above described product. Such details are not repeated explicitly herein for the sake of conciseness and brevity of the disclosure.

The present application proceeds further by describing additional embodiments of the invention.

In the present application, embodiments relate to using molten metal where the bulk metal i.e. the solid metal material is melted at higher temperature (typical > 150 °C) to transfer the bulk into the liquid phase. It will be deposited / printed / dispensed in the liquid phase and solidified upon interacting with the substrates. Typical materials can be but not restricted to the following:
- Tin (Sn), melting point 231.93 °C with an electrical conductivity of 8.7×10⁶ S/m
- Tin silver copper solder (SAC305 - 96.5Sn-3.5Ag-0.5Cu alloy), melting point 217 °C with an electrical conductivity of 7.69×106 S/m
- Bismuth tin silver solder (57Bi-42Sn-1Ag), melting point 137-139 °C with an electrical conductivity of 2.62×10⁶ S/m
- ZAMAK (Zinc aluminum alloy), melting point -390 °C with an electrical conductivity of 14.6×10⁶ S/m
- Aluminum alloy (e.g. AISi12), melting point - 660 °C with an electrical conductivity of 20.3×10⁶ S/m

In principle, it can be a pure metal or alloy with the main metal from tin, bismuth, indium, zinc, aluminum, lead, cadmium, lithium, thallium, gold with a minor metal parts (<12%) with silver, copper, nickel, and many more.

Conductive metallic structures do not comprise porous particles and/or flacks and/or grains of metal, whereas the prior art typically does comprise them. During the thermal forming, the polymer as well as the metal structure may be stretched and deformed. Due to this porous intrinsic attribute, cracks and disconnection could occur at different 3D forming structures. Consequently, the electrical conductivity may also deviate according to the bending / 3D forming. On the contrary, the present invention relates to using solid metal material (e.g. (soft) bulk metals as tin alloys). The metallic structures may thus have 100% metal content and can conformally follow the 3D shape of the mold during the thermal forming. Therefore, there is low risk of disconnecting and no deviation on electrical conductivity. The change of electrical conductance is also limited and could happen due to the change of cross-section area because of stretching.

Embodiments of the invention comprise: directly deposit bulk metal onto polymer substrates (e.g. non-contact printing molten bulk metal); 3D-deform the multi-layer structure by applying heat and/or pressure (e.g. thermoforming, hot embossing, etc.) (can be one side or both sides); result in complex and conformal hybrid 3D structures (metal + polymer). The embodiments may comprise the following unique and distinguishing features, in addition to the already described features of the present disclosure, compared to the prior art: merged bulk metal structure into polymer substrates; smoothed, flattened, and conformed 3D metal structures following 3D mold shapes; high forming flexibility of the printed metal structures, e.g. - 90° bending, forming into micro-channels, various stretching directions; 2-step process: printing and forming; no pre- and post-treatment preferred (e.g. sintering, plasma surface activation); additional electronic or photonic components can be directly assembled via metal deposition, i.e. molten metal printing method can also be used as soldering of the electronic components; Can work with polymer substrate with low melting point (e.g. 60° C).

Embodiments of the invention comprise a specific example, wherein the metal lines and grids were printed onto a thin polymer foil (COC: Cyclic olefin copolymer, thickness of 200 µm), after direct printing, the metal lines and grids were thermal formed at a peak temperature of 160 °C using a PDMS mold with complex microfluidic channels and reservoirs. The lines and grids were not re-designed to fit the thermal forming mold to test the flexibility and reliability of the metal structure during the thermal forming process. The metal lines follow conformally and perfectly of the 3D mold together with the 200 µm thick COC polymer foil. The embodiments may comprise the following unique and distinguishing features, in addition to the previously described features in the present disclosure, compared to the prior art:
- The metallic structure (e.g. printed bulk metal structure) was printed from the metal alloy 57Bi-42Sn-1Ag with a melting range of 137-139 °C. It was first melted at 320 °C in the reservoir of the StarJet printhead, which is much higher than the melting point of the metal. Even though, almost no damage of the polymer foil was observed.
- High adhesion between printed metal structure and polymer foils.
- In contrary to the conventional metal nanoparticles dispersed in the ink or paste form, the bulk metal was directly deposited in the molten/liquid form (e.g. by melting at a temperature higher than the melting point of the bulk metal), and the metal become solid by phase changing as it gets cooled down automatically during the deposition process.
- The metal material (e.g. bulk metal), in this example the tin alloys, has relative good flexibility during the forming process under heat and/or pressure. The metallic structure takes the shape of the mold and forms conformal 3D structures together with the polymer substrates.
- The thermal forming temperature (e.g. 160 °C) can also be higher than the melting point of the metal (e.g. 137-139 °C for 57Bi-42Sn-1Ag), and the metal lines can be partly remelt, flattened (re-shaped), and smoothed during the thermal forming process.
- In the case of thermal forming temperature (160 - 180 °C) is lower than the melting point of printed metal (e.g. 217 °C for 96.5Sn-3.5Ag-0.5Cu or SAC305 in abbreviation), the original line shape was maintained, but the whole structure was pushed into the polymer foil.
- The bulk electrical conductivity of the metal material (e.g. bulk metal) was achieved. High electrical conductance was maintained after thermal forming.

Embodiments of the invention comprise conformal multilayer electronics such as planar 3D-printed multi-layer PCBs, which can be direct thermal formed into desired 3D shapes for e.g. automotive applications, white goods applications, etc. It can be produced by layer-by-layer printing of polymer (e.g. via FDM/FFF technology), 2D and vertical conductive traces (e.g. StarJet technology), and pick-and-placed, soldered electronic components. Sensors and electrodes can be fully embedded or on the surface for interaction. The advantages provided by the embodiment comprise: conform shapes to fit application requirements, higher 3D shape complexity, better surface finishing (remelting and smoothing), oriented sensors and components into the proper orientation (difficult to achieve in 3D printing). The embodiments may comprise the following unique and distinguishing features, in addition to the already described features of the present disclosure, compared to the prior art: Prior art allows stacking of multiple thin films with printed electronics on the foils. However, interconnection between layers (i.e. vertical connections) is hardly found in the prior art. It can be done afterwards if vertical holes were designed and filled in the post-processing. In embodiments of the invention, this can be achieved by hybrid 3D printing and then thermally formed into the desired 3D shapes.

Embodiments of the invention comprise even more advanced applications such as complex 3D electronics. Via multi-material 3D electronics additive manufacturing, complex and freeform 3D polymer shapes with embedded multilayer electronic circuits can be direct printed (additive manufacturing). However, surface smoothness and shape fidelity are still limited. For example, in the application of producing an integrated ear blood pressure sensor via an individual ear plug fitting dedicated patent, the 3D printing may not 100% replicate the human ear structure. In this case, the contact area to the patient's ear needn't be directly printed into the shape but can be kept as a planar surface and thermoformed subsequently. These embodiments comprise the planar surface, which is mainly made of thermoplastic, 2D electrodes / conductive traces and interconnected sensors, can be then directly 3D formed via e.g. hot embossing, and the printed electrodes can then conformally take the exact shape of the patient ear topology so that the sensor can directly measure the ear blood pressure without errors due to air gap / miss placement / vibration during movement, etc.

The embodiments of the invention comprise the following unique and distinguishing features, in addition to the already described features of the present disclosure, compared to the prior art: have not been reported in the prior art; have an embedded 3D electronics and at least one surface conformally shaped to the application with electronic circuits & sensors.

Advantages provided by embodiments of the invention comprise: highly simplified process with StarJet molten metal printing; higher reliability and reproducibility due to metal material, created solder structures thus are also flexible and stretchable; direct soldering of components before or after thermoforming is possible; compatibility with various substrates, less thermal compatibility issues.

Embodiments of the invention comprise a multi-material structure consisting of at least two layers, where one layer is a metal structure made of bulk metal, and the second layer is a polymer (thermal formable polymer, e.g. Tg lower than 600 °C), where at least on one side heat and/or pressure are applied from a tool to deform the multi-material structure, where the bulk metal structures take the shape of the tool and merge into the underneath/above substrates, where the components can be directly soldered before deforming. Further embodiments may, additionally or alternatively, comprise the electronic components, which can be integrated first and directly soldered via StarJet technology (possibly, no adhesives required) selectively. Further embodiments may, additionally or alternatively, comprise additional layers (which can be pre-structured) which can also be added on top to (partly) seal the molded structures. Further embodiments may, additionally or alternatively, comprise other additional processes can be added afterwards (printing functional layers, assembly of components.

The embodiments of the invention may comprise the following distinguishing features (e.g. novelties):
- Direct use of the solid metal material (e.g. bulk metal) for in-mold electronic application, no solvent, non-metallic additives
- High adhesion to the substrate due to localized thermal impact compared to liquid metal
- Digital printing (via drop-on-demand printing) to create freeform conductive metal structures. On the contrary, liquid metal is currently restricted to extrusion (direct writing) and has limited structure possibility and high difficulties in 3D / vertical structures.
- 3D deforming of the planar bulk metal but still maintaining the electrical conductivity.
- High electrical conductance after thermal forming process. Practically, although the electrical conductivity is in the similar range before thermal forming (2 - 20 × 10⁶ S/m). Our printed line has much higher line height (300 µm vs less than 5 µm by prior art). The electrical conductance is typically 50 -100 times higher before thermal forming, and 100 -400 times higher after thermal forming (exact numbers depending on each cases, and need to be verified).
- Much simpler process (e.g. 2 steps) and using cost-efficient material. Solder costs less than 80 €/Kg, and thermal forming inks cost > 2600 €/kg..
- No need of post-treatment or/and pre-treatment. Prior art requires drying of the solvent inside the metal inks, curing (e.g. heating at 200 °C in oven) of the metal inks which make the process more expensive and inflexible
- (Partly and/or in short duration) Remelting the bulk metal structure, smooth, flatten, and re-shape the metal into complex 3D molded shapes without compromising the original structure.
- Direct thermoforming of multi-material 3D printed complex structures with high shape fidelity
- Different metal alloys can be combined for different structures (such as low melting point for electrical contacts and pads due to the smoothing effect, high melting point alloys for finer pitch interconnections and stable shape fidelity)

In the following, additional embodiments, and details thereof, relating to the invention are presented, which may individually or in combination be used to form further embodiments when transferred onto a different embodiment. The description further proceeds with embodiments relating to fabrication of the polymer structure or the polymer layers using additive manufacturing technologies (e.g. 3D printing).

According to some embodiments, the polymer structure or the plurality of polymer layers may be fabricated using additive manufacturing technologies such as a fused deposition modeling (FDM) or fused filament fabrication (FFF) process so as to form insulating layers. Therefore, the method may fabricate conformal multi-layer electronics.

For example, a method for fabricating conformal multi-layer electronics comprises: additive manufacturing of a planar multi-layer printed circuit board (PCB) by sequentially depositing: a polymer material to form insulating layers, using a fused deposition modeling (FDM) or fused filament fabrication (FFF) process; conductive traces, including both planar and vertical interconnections, using a jet printing process such as StarJet; and placement and soldering of electronic components using a pick-and-place system. The method further comprise thermally forming the planar multi-layer PCB into a desired three-dimensional (3D) shape, and embedding sensors and electrodes either fully within or on the surface of the PCB for functional interaction. For example, embodiments according to Fig. 5 may correspond to such conformal multi-layer electronics.

### Embodiment relating to fabrication process for thermoformed Hybrid Multi-Layer PCBs

Some embodiments relate to a method of fabricating, or manufacturing a product as a planar multi-layer printed circuit board (PCB) using hybrid additive manufacturing techniques. That is, the method comprises using hybrid additive manufacturing technology. The method, or equivalently the process, begins with the deposition of insulating polymer layers through fused deposition modeling (FDM) or fused filament fabrication (FFF) technology to form a base structure of the product. Conductive traces are then printed in both planar and vertical orientations using the StarJet or similar printing technology, ensuring seamless interconnections between layers without requiring post-processing. Electronic components, such as integrated circuits, resistors, or capacitors, are placed onto the structure using a pick-and-place system and soldered for functionality. Once the planar PCB is complete, it undergoes thermal forming to achieve the desired 3D shape, conforming to specific application requirements such as integration into automotive interiors or household appliances. For example, the PCB 500 according to Fig. 5 may correspond to the PCB described here.

According to some embodiments, the three-dimensional deforming enhances surface finish by remelting and smoothing the polymer structure or the plurality of polymer layers, thereby improving mechanical integrity and aesthetic quality of the polymer structure or the plurality of polymer layers.

For example, the method for fabricating conformal multi-layer electronics, wherein the thermal forming process or any other method of heat application that enhances the surface finish by remelting and smoothing the polymer layers, thereby improving mechanical integrity and aesthetic quality of the 3D structure.

### Embodiment relating to thermal forming for enhanced shape and surface Finish

Some embodiments relate to the planar multi-layer PCB, fabricated as described earlier, thermally formed into a complex 3D shape. The thermal forming process not only allows the PCB to conform to the geometric requirements of the intended application but also enhances the surface quality of the polymer layers. By re-melting the polymer surface during the thermal forming process, the re-melting structure achieves a smoother and more aesthetically pleasing finish, which is crucial for applications requiring high-quality appearance or mechanical robustness. For example, such stages of remelting and smoothing described here may be implemented in any of the embodiments according to Fig. 1 to 7.

According to some embodiments, the one or more electronic components and/or photonic components such as sensors are arranged and soldered to the polymer structure or the plurality of polymer layers using a pick and place system, and oriented during fabrication of the polymer structure or the plurality of polymer layers to align with specific axes or angles for achieving optimal functional performance in the specific shape such as a final 3D shape which is otherwise difficult to achieve with conventional 3D printing techniques.

For example, sensors and electronic components are oriented during fabrication to align with specific axes or angles for optimal functional performance in the final 3D shape, which is otherwise difficult to achieve with conventional 3D printing techniques.

### Embodiment relating to orientation of sensors and components

Some embodiments relate to the fabrication method ensuring precise orientation of sensors and electronic components during the additive manufacturing process. Through careful placement and alignment during the pick-and-place stage, components such as accelerometers, gyroscopes, or electrodes are embedded or mounted in positions that align with specific axes or functional orientations. This precise alignment ensures optimal performance in the final 3D structure, a feature particularly valuable in applications such as robotics or wearable electronics, where sensor orientation is critical.

According to some embodiments, the further metallic structures between the plurality of layers are generated during the fabrication of the plurality of polymer layers, reducing the need for post-processing steps such as drilling and filling, thereby improving manufacturing efficiency and electrical connectivity.

For example, the vertical interconnections between layers are directly fabricated during the additive manufacturing process, eliminating the need for post-processing steps such as drilling and filling, thereby improving manufacturing efficiency and ensuring seamless electrical connectivity. For example, such vertical interconnections may correspond to the further metallic structures in embodiments according to Fig. 5.

According to some embodiments, the three-dimensional deforming is adapted to obtain the specific shape as customized 3D shapes tailored for specific applications, such as fitting into irregular or space-constrained enclosures in automotive or consumer electronics.

For example, the thermal forming process is adapted to create customized 3D shapes tailored for specific applications, such as fitting into irregular or space-constrained enclosures in automotive or consumer electronics. For example, such adapted three-dimensional deforming may be implemented in any of the embodiments according to Fig. 1 to 7.

Although some aspects have been described in the context of a method, it is clear that these aspects also represent a description of the corresponding product, where a method step or stage corresponds to a product/device/component or a feature of product/device/component.

Analogously, aspects described in the context of an apparatus i.e. represented as a description of a corresponding block or item or feature of a corresponding method.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus, the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

While this invention has been described in terms of several embodiments, there are alterations, permutations, and equivalents which fall within the scope of this invention. It should also be noted that there are many alternative ways of implementing the methods and compositions of the present invention. It is therefore intended that the following appended claims be interpreted as including all such alterations, permutations and equivalents as fall within the scope of the present invention as defined by the appended claims.

### References

[1] M. Beltrão, F. M. Duarte, J. C. Viana, and V. Paulo, "A review on in-mold electronics technology," Polymer Engineering & Science, vol. 62, no. 4, pp. 967-990, 2022, doi: 10.1002/pen.25918.
[2] https://e2ip.com/newsevents/what-is-in-mold-electronics/
[3] https://promwad.com/news/mold-electronics-ime-how-it-works-and-why-its-new-trend
[4] "Printed electronics," *Wikipedia.* Jun. 29, 2024. Accessed: Aug. 05, 2024. [Online]. Available:
   https://en.wikipedia.org/w/index. php?title=Printed_electronics&oldid=1231702674
[5] https://www.stannol.de/en/products/solder-paste/detail/sp2200/272/bleifrei
[6] https://www.stannol.de/en/products/solder-wire/detail/massiv-nsl/249/massivdraht
[7] https://www.stannol.de/en/products/solder-bars/detail/tsc305/198/bleifrei
[8] DE102008057291B4
[9] US8877145B2
[10] https://iopscience.iop.org/article/10.1088/1361-6439/aab928
[11] https://www.hahn-schickard.de/forschung-entwicklung/mikrofluidik-mikrodosierung/hybrid-3d-drucker
[12] https://onlinelibrary.wiley.com/doi/full/10.1002/adem.202300922
[13] https://onlinelibrary.wiley.com/doi/10.1002/tee.24035
[14] EP Patent application submitted (Application No. EP23211208.6)
[15] https://www.hahn-schickard.de/fertigungstechnologien/aufbau-und-verbindungstechnik/selektives-loeten
[16] https://www.mdpi.com/2072-666X/15/6/743
[17] https://www.sciencedirect.com/science/article/abs/pii/ S0927024818300825?via%3Dihub
[18] https://libraη.imaging.org/print4fab/articles/34/1/art00018_1
[19] https://en.wikipedia.org/wiki/ln-mould_decoration
[20] https://en.wikipedia.org/wiki/ln-mould_labelling
[21] https://www.ccieurolam.com/wp-content/uploads/ME603-Data-Sheet.pdf
[22] https://iopscience.iop.org/article/10.1088/1361-665X/aa5cca/meta

## Claims

1. Method (100) of manufacturing a product (400, 500, 600, 700), the method (100) comprising:
melting (104) a solid metal material to obtain a molten metal material;
applying (108) the molten metal material onto a polymer structure (220, 320₁₋₂; 420; 520; 620₁₋₅; 720₁₋₃) deformable by applying heat and/or pressure, wherein the molten metal material solidifies upon coming into contact with the polymer structure (220, 320₁₋₂; 420; 520; 620₁₋₅; 720₁₋₃) so as to form metallic structures (210₁₋₄; 310₁₋₂; 410₁₋₂; 510₁₋₁₀; 610₁₋₄; 710₁₋₆) of customizable shape and structure; and
three-dimensional deforming (112) the polymer structure (220, 320₁₋₂; 420; 520; 620₁₋₅; 720₁₋₃) including the metallic structures (210₁₋₄; 310₁₋₂; 410₁₋₂; 510₁₋₁₀; 610₁₋₄; 710₁₋₆) by providing heat and/or pressure to the polymer structure (220, 320₁₋₂; 420; 520; 620₁₋₅; 720₁₋₃) including the metallic structures (210₁₋₄; 310₁₋₂; 410₁₋₂; 510₁₋₁₀; 610₁₋₄; 710₁₋₆) so as to obtain a specific shape.

2. The method (100) of claim 1, wherein the three-dimensional deforming (112) is performed so that the metallic structures (210₁₋₄; 310₁₋₂; 410₁₋₂; 510₁₋₁₀; 610₁₋₄; 710₁₋₆) and the polymer structure (220, 320₁₋₂; 420; 520; 620₁₋₅; 720₁₋₃) having the specific shape are conformally formed.

3. The method (100) of any of the previous claims, wherein the solidified molten metal material is sunken into the polymer structure (220, 320₁₋₂; 420; 520; 620₁₋₅; 720₁₋₃).

4. The method (100) of any of claims 1 to 3, wherein the metallic structures (210₁₋₄; 310₁₋₂; 410₁₋₂; 510₁₋₁₀; 610₁₋₄; 710₁₋₆) comprise at least one electrical conductor track (210₁₋₂; 310₁; 410₁₋₂; 510₁₋₁₀; 710₁₋₂), preferably, comprising a linewidth (230, 330, 430) ranging between 10 and 1000 µm.

5. The method (100) of any of claims 1 to 4, further comprising:
applying one or more electronic and/or photonic components (535₁, 535₂; 635₁, 735) (for example SMD components) onto the polymer structure (220, 320₁₋₂; 420; 520; 620₁₋₅; 720₁₋₃); and
interconnecting the metallic structures (210₁₋₄; 310₁₋₂; 410₁₋₂; 510₁₋₁₀; 610₁₋₄; 710₁₋₆) and the one or more electronic and/or photonic components (535₁, 535₂; 635₁, 735) before or
after the three-dimensional deforming of the polymer structure (220, 320₁₋₂; 420; 520; 620₁₋₅; 720₁₋₃) including the metallic structures (210₁₋₄; 310₁₋₂; 410₁₋₂; 510₁₋₁₀; 610₁₋₄; 710₁₋6).

6. The method (100) of any of the previous claims, further comprising: covering the metallic structures (210₁₋₄; 310₁₋₂; 410₁₋₂; 510₁₋₁₀; 610₁₋₄; 710₁₋₆) by a covering polymer layer or by over-molding with an over-molding polymer either prior to or after the three-dimensional deforming (112) of the polymer structure (220, 320₁₋₂; 420; 520; 620₁₋₅; 720₁₋₃) including the metallic structures (210₁₋₄; 310₁₋₂; 410₁₋₂; 510₁₋₁₀; 610₁₋₄; 710₁₋₆).

7. The method (100) of any of the previous claims, further comprising: providing the heat and/or the pressure to the metallic structures (210₁₋₄; 310₁₋₂; 410₁₋₂; 510₁₋₁₀; 610₁₋₄; 710₁₋₆) using at least one mold (745), wherein the at least one mold (745) is configured to provide the specific shape.

8. The method (100) of claim 7, wherein the at least one mold (745) is further configured to provide the product (400, 500, 600, 700) with microfluidic structures (360₁, 360₂).

9. The method (100) of any of the previous claims, wherein the three-dimensional deforming (112) comprises thermo-forming or hot embossing.

10. The method (100) of any of the previous claims, further comprising: applying the molten metal material as microdroplets and/or jets onto the polymer structure (220, 320₁₋₂; 420; 520; 620₁₋₅; 720₁₋₃) from a specific distance, preferably by applying the molten metal material onto the polymer structure (220, 320₁₋₂; 420; 520; 620₁₋₅; 720₁₋₃) through a nozzle.

11. The method (100) of any of the previous claims, comprising:
providing a multi-layer structure (505) comprising a plurality of polymer layers, wherein the metallic structures (210₁₋₄; 310₁₋₂; 410₁₋₂; 510₁₋₁₀; 610₁₋₄; 710₁₋₆) are formed on at least two of the plurality of polymer layers by applying the molten metal material onto the corresponding polymer layer; and
generating further metallic structures (525₁₋₅) interconnecting the corresponding metallic structures (210₁₋₄; 310₁₋₂; 410₁₋₂; 510₁₋₁₀; 610₁₋₄; 710₁₋₆) formed on different polymer layers before or after three-dimensional deforming the multi-layer structure (505).

12. The method (100) of claim 11, further comprising: applying at least one electronic and/or photonic component (535₁, 535₂; 635₁, 735) onto at least one of the plurality of polymer layers, wherein at least one of the metallic structures (210₁₋₄; 310₁₋₂; 410₁₋₂; 510₁₋₁₀; 610₁₋₄; 710₁₋₆) and/or at least one of the further metallic structures (525₁₋₅) is connected to the at least one electronic and/or photonic component (535₁, 535₂; 635₁, 735).

13. The method (100) of any of the previous claims, wherein the solid metal material has a melting point in a range between 100° -1200° C, wherein the solid metal material preferably comprises at least one of Tin (Sn), Tin silver copper solder (SAC305 - 96.5Sn-3.5Ag-0.5Cu alloy), Bismuth tin silver solder (57Bi-42Sn-1Ag), ZAMAK (Zinc aluminium alloy) and Aluminium alloy (e.g. AlSi₁₂).

14. The method (100) of any of the previous claims, wherein the polymer structure (220, 320₁₋₂; 420; 520; 620₁₋₅; 720₁₋₃) or the plurality of polymer layers have a melting point in a range between 50° - 500° C, wherein the polymer structure (220, 320₁₋₂; 420; 520; 620₁₋₅; 720₁₋₃) or the plurality of polymer layers preferably comprise cyclic olefin copolymer, COC.

15. The method (100) of any of the previous claims, wherein the polymer structure (220, 320₁₋₂; 420; 520; 620₁₋₅; 720₁₋₃) or the plurality of polymer layers are fabricated using additive manufacturing techniques such as a fused deposition modeling (FDM) or fused filament fabrication (FFF) process so as to form insulating layers.

16. A product (400, 500, 600, 700) obtainable by a method (100) according to any of the previous claims 1 to 15, comprising:
a polymer structure (220, 320₁₋₂; 420; 520; 620₁₋₅; 720₁₋₃);
one or more electronic and/or photonic components (535₁, 535₂; 635₁, 735);
metallic structures (210₁₋₄; 310₁₋₂; 410₁₋₂; 510₁₋₁₀; 610₁₋₄; 710₁₋₆) comprising a metal material, preferably, wherein the metallic structures (210₁₋₄; 310₁₋₂; 410₁₋₂; 510₁₋₁₀; 610₁₋₄; 710₁₋₆) are connected to at least one of the one or more electronic and/or photonic components (535₁, 535₂; 635₁, 735);
wherein the metal material of the metallic structures (210₁₋₄; 310₁₋₂; 410₁₋₂; 510₁₋₁₀; 610₁₋₄; 710₁₋₆) is sunken into the polymer structure (220, 320₁₋₂; 420; 520; 620₁₋₅; 720₁₋3);
wherein the metallic structures (210₁₋₄; 310₁₋₂; 410₁₋₂; 510₁₋₁₀; 610₁₋₄; 710₁₋₆) and the polymer structure (220, 320₁₋₂; 420; 520; 620₁₋₅; 720₁₋₃) together are three-dimensionally deformed to have the specific shape; and
wherein the metallic structures (210₁₋₄; 310₁₋₂; 410₁₋₂; 510₁₋₁₀; 610₁₋₄; 710₁₋₆) and the polymer structure (220, 320₁₋₂; 420; 520; 620₁₋₅; 720₁₋₃) having the specific shape are conformally formed.
